# FASCICULE DE BREVET EUROPEEN

(11) **EP 2 975 645 B1**
(45) Date de publication et mention de la délivrance du brevet: **01.02.2017**
(21) Numéro de dépôt: 15176175.6
(22) Date de dépôt: 09.07.2015
(51) Int. Cl.: H01L 21/265, H01L 29/66, H01L 21/3065, H01L 21/8238, H01L 21/8234, H01L 21/31, H01L 21/311, H01L 21/3115, H01L 29/51, H01L 29/16

(54) **PROCÉDÉ DE FORMATION DES ESPACEURS D'UNE GRILLE D'UN TRANSISTOR**
VERFAHREN ZUR HERSTELLUNG VON ABSTANDSHALTERN EINES GATES EINES TRANSISTORS
METHOD FOR FORMING SPACERS OF A TRANSISTOR GATE

(30) Priorité: 18.07.2014 FR 1456929
(43) Date de publication de la demande: 20.01.2016
(73) Titulaire: COMMISSARIAT A L'ENERGIE ATOMIQUE ET AUX ENERGIES ALTERNATIVES, 75015 Paris (FR)
(72) Inventeur: POSSEME, Nicolas, 38000 GRENOBLE (FR)
(74) Mandataire: Hautier, Nicolas

(56) Documents cités:
- EP-A1- 2 750 170
- US-A1- 2004 014 305
- US-A1- 2007 232 006
- US-A1- 2013 252 430
- ROMUALD BLANC ET AL: "Patterning of silicon nitride for CMOS gate spacer technology. I. Mechanisms involved in the silicon consumption in CH3F/O2/He high density plasmas", JOURNAL OF VACUUM SCIENCE & TECHNOLOGY B: MICROELECTRONICS AND NANOMETER STRUCTURES, vol. 31, no. 5, 1 janvier 2013 (2013-01-01), page 051801, XP055171054, ISSN: 2166-2746, DOI: 10.1116/1.4816466

## Description

### DOMAINE TECHNIQUE DE L'INVENTION

La présente invention concerne en général les transistors à effet de champs (FET) utilisés par l'industrie de la microélectronique et plus particulièrement la réalisation des espaceurs de grille des transistors de type métal-oxyde-semiconducteur (MOSFET) majoritairement utilisés pour la production de toutes sortes de circuits intégrés.

### ÉTAT DE LA TECHNIQUE

La course incessante à la réduction des dimensions qui caractérise toute l'industrie de la microélectronique n'a pu se faire qu'avec l'apport d'innovations clés tout au long de décennies de développement depuis que les premiers circuits intégrés ont été produits industriellement dans les années soixante. Une innovation très importante qui remonte aux années soixante-dix, et qui est toujours utilisée, consiste à réaliser les transistors MOSFET à l'aide d'une technique dans laquelle les électrodes de source et de drain sont auto alignés sur celles de grille et ne nécessitent donc pas d'opération de photogravure pour leur définition. Combiné avec l'utilisation de grilles en silicium polycristallin, ce sont les grilles elles-mêmes, réalisées en premier, qui servent de masque lors du dopage des zones de source et drain des transistors.

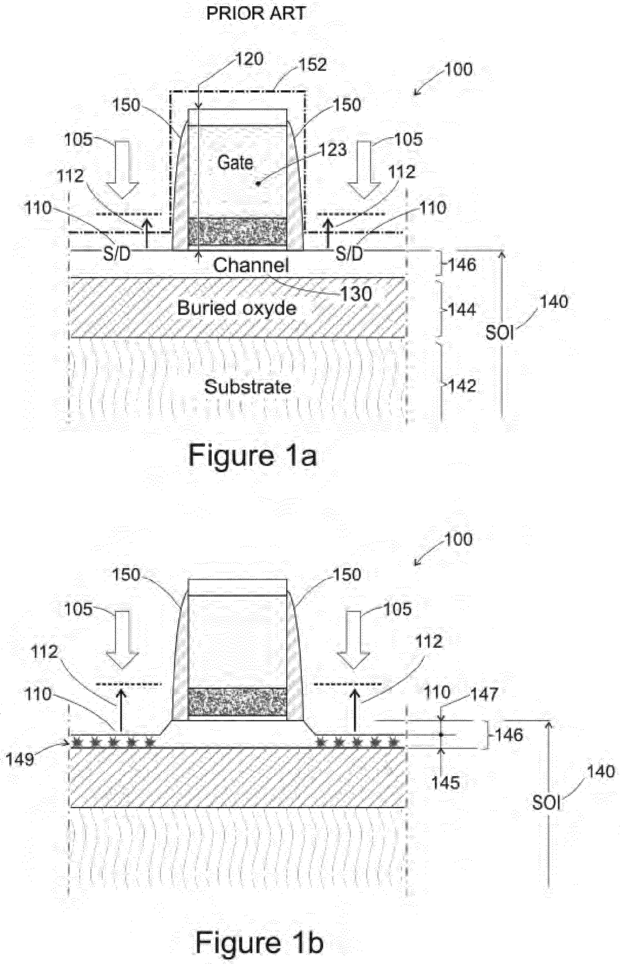

La **figure 1a** est une vue en coupe d'un exemple de ce type de transistor 100 en cours de réalisation. On y retrouve les zones de source et de drain 110, globalement désignées zones source/drain, puisqu'elles sont très généralement parfaitement symétriques et peuvent jouer les deux rôles en fonction des polarisations électriques qui sont appliquées au transistor. La grille est classiquement constituée d'un empilement de couches 120 dont une grande partie est toujours constituée de silicium polycristallin 123. La formation des zones de source et drain se fait typiquement par implantation ionique 105 de dopants dans les zones 110, la grille 120 servant de masque comme mentionné ci-dessus, empêchant ainsi le dopage de la zone du transistor MOSFET dans laquelle, en fonction des tensions appliquées sur la grille, va pouvoir se développer le canal 130 de conduction entre source et drain.

La technique de base, très brièvement décrite ci-dessus, bien connue de l'homme du métier ainsi que de nombreuses variantes, a été constamment perfectionnée dans le but d'améliorer les performances électriques des transistors tout en permettant d'accommoder les réductions de taille successives des transistors nécessitées par une intégration toujours croissante d'un plus grand nombre de composants dans un circuit intégré.

Une technique largement utilisée actuellement consiste à fabriquer les circuits intégrés en partant de substrats élaborés 140 de type silicium sur isolant, désignés par leur acronyme SOI, de l'anglais « silicon on insulator ». Le substrat élaboré SOI est caractérisé par la présence d'une fine couche superficielle de silicium monocristallin 146 reposant sur une couche continue d'oxyde de silicium 144, dit oxyde enterré ou encore BOX, acronyme de l'anglais « buried oxide layer ». La solidité et la rigidité mécanique de l'ensemble sont assurées par la couche 142 qui constitue le corps du substrat SOI, souvent qualifié du vocable anglais de « bulk » pour indiquer que le substrat de départ est très généralement fait de silicium massif. Cette structure offre de nombreux avantages pour la réalisation des transistors MOSFET. Notamment, elle permet une réduction drastique des capacités parasites en raison de la présence de la couche continue isolante 144. En ce qui concerne l'invention, on retiendra seulement que la couche superficielle de silicium monocristallin 146 peut être contrôlée précisément en épaisseur et en dopage. En particulier, il est avantageux pour les performances des transistors que le canal 130 puisse être complètement déserté de porteurs, c'est-à-dire « fully depleted » (FD), vocable anglais qui est généralement utilisé pour désigner cet état. Ceci est obtenu en réalisant les transistors à partir de substrats SOI dont la couche superficielle 146 est très mince ce qui n'est pas sans inconvénient par ailleurs comme on le verra dans la description de l'invention. Ce type de transistor est ainsi désigné par l'acronyme FDSOI.

Un perfectionnement de la technique de base d'auto alignement qui a été universellement adopté consiste en la formation d'espaceurs 150 sur les flancs de la grille. Les espaceurs 150, typiquement faits de nitrure de silicium (SiN), vont permettre en particulier la mise en oeuvre d'une technique dite de « Source et Drain surélevés ». Pour pouvoir maintenir de faibles résistances électriques d'accès aux électrodes de source et de drain, en dépit de la réduction de taille des transistors, il a fallu en effet augmenter leur section. Ceci est obtenu par épitaxie sélective des zones source/drain 110. Au cours de cette opération on va faire croître 112 localement la couche initiale de silicium monocristallin 146. Il faut alors protéger les zones de grilles pour empêcher la croissance de se faire également à partir du silicium polycristallin 123 de la grille. C'est, entre autres, le rôle des espaceurs que d'assurer cette fonction. Ils assurent également un rôle de préservation de la grille lors de la siliciuration des contacts (non représentée) qui est ensuite effectuée dans le même but afin de diminuer la résistance série d'accès aux électrodes du transistor.

La formation des espaceurs 150 est devenue une étape cruciale de formation des transistors qui atteignent désormais des dimensions qui se mesurent couramment en nanomètres (nm = 10⁻⁹ mètres) et qui sont globalement de tailles décananométriques. La réalisation des espaceurs se fait sans faire intervenir aucune opération de photogravure. Ils sont auto alignés sur la grille 120 à partir du dépôt d'une couche uniforme de nitrure de silicium 152 (SiN) qui subit ensuite une gravure très fortement anisotrope. Cette gravure du SiN attaque préférentiellement les surfaces horizontales, c'est-à-dire toutes les surfaces qui sont parallèles au plan du substrat SOI. Elle ne laisse en place, imparfaitement, que les parties verticales de la couche 152, celles sensiblement perpendiculaires au plan du substrat, afin d'obtenir en pratique les motifs 150 dont la forme idéale serait évidemment rectangulaire.

Avec les solutions connues, la réduction de taille des transistors rend très délicate l'obtention d'espaceurs jouant pleinement leur rôle d'isolation et n'induisant pas de défauts dans la réalisation de transistors à partir de substrats SOI. En effet, dans le cadre de la présente invention, et comme cela sera détaillé par la suite, il a été constaté que plusieurs types de défaut tels que ceux mentionnés ci-dessous apparaissent lors de la gravure des espaceurs en utilisant l'un ou l'autre des procédés connus de gravure anisotrope.

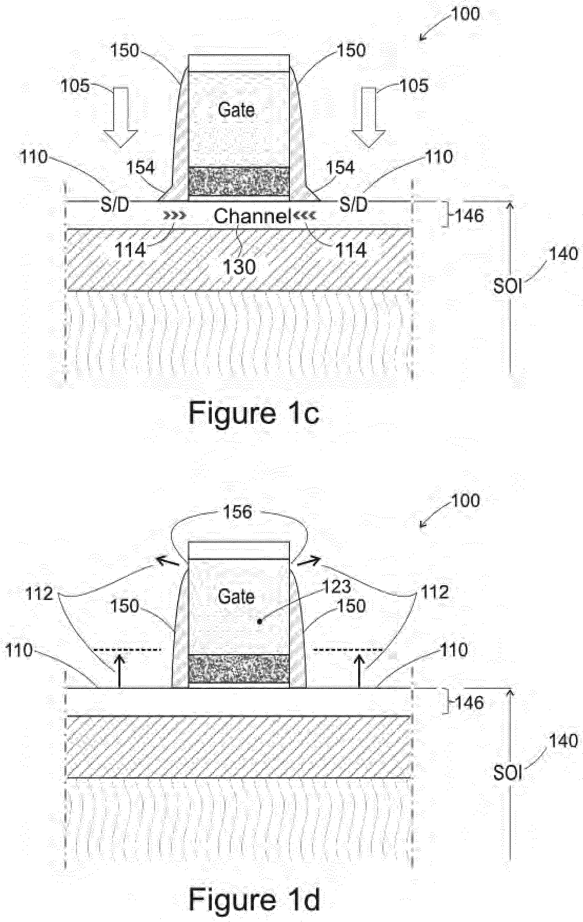

Les **figures 1b****,** **1c et 1d** illustrent chacune un type de défaut observé.

On utilise notamment un type de gravure qui est dite « sèche » et qui se met en oeuvre à l'aide d'un procédé qui est le plus souvent désigné par son acronyme RIE, de l'anglais « reactive-ion eching », c'est-à-dire : « gravure ionique réactive ». Il s'agit d'un procédé de gravure dans lequel on forme, dans une enceinte confinée, un plasma qui réagit physiquement et chimiquement avec la surface de la tranche à graver. Dans le cas de la gravure d'une couche de nitrure de silicium, qui est comme on l'a vu le matériau préféré pour la réalisation des espaceurs, le gaz réactif est typiquement le fluorure de méthyle (CH3F) que l'on fait réagir avec le matériau à graver en introduisant également du dioxygène (02). On forme ainsi un plasma de gravure basé sur la chimie du fluor et souvent désigné par ses constituants : CH3F/O2/He. Dans ce plasma le composé fluor sert à graver le nitrure de silicium tandis que l'oxygène permet de limiter la polymérisation du fluorure de méthyle et sert également à oxyder le silicium lorsque ce matériau est atteint en cours de gravure. La couche d'oxyde formée sur le silicium permet de ralentir la gravure du silicium au prix cependant d'une transformation en surface de ce dernier en oxyde et donc d'une consommation superficielle de silicium. L'hélium sert de diluant pour l'oxygène.

L'avantage de ce type de gravure est qu'elle est assez anisotrope et permet de contrôler suffisamment le profil des espaceurs 150 même si l'on ne peut pas obtenir en pratique la forme rectangulaire idéale. L'inconvénient de ce type de gravure est que la sélectivité d'attaque du silicium sous-jacent est cependant limitée. La sélectivité, c'est-à-dire le rapport des vitesses de gravure entre le nitrure de silicium et le silicium est de l'ordre de 10 et peut atteindre 15 au maximum en fonction des conditions de formation du plasma (le nitrure est gravé 10 à 15 fois plus vite que le silicium).

On utilise aussi des gravures dites « humides » à base d'acide fluorhydrique (HF) ou d'acide phosphorique (H3PO4) qui ont une bien meilleure sélectivité, respectivement, vis-à-vis du silicium ou de son oxyde (SiO2) mais qui ne permettent pas cependant de contrôler le profil des espaceurs puisque la gravure est essentiellement isotrope dans ce cas. On notera ici que ce type de gravure est aussi qualifié de « nettoyage humide » traduction de l'anglais « wet clean ».

On notera ici qu'il existe de nombreuses publications sur le sujet de la gravure du nitrure de silicium et/ou des espaceurs de grille en général. On pourra se référer par exemple aux brevets ou demandes de brevets américains suivants : 2003/0207585 ; 4 529 476 ; 5 786 276 et 7 288 482. Le brevet Européen EP2750170-A1 divulgue un procédé de formation d'espaceurs d'une grille d'un transistor à effet de champ, la grille étant située au-dessus d'une couche active en un matériau semi-conducteur, comprenant une étape de formation d'une couche à base de nitrure recouvrant la grille dudit transistor, le procédé comprenant après l'étape de formation de la couche à base de nitrure :- au moins une étape de modification de la couche à base de nitrure par mise en présence de la couche à base de nitrure avec un plasma qui créé un bombardement d'ions à base d'hydrogène (H, H+ , H2 + , H3 + etc.), le bombardement étant anisotrope selon une direction privilégiée parallèle à des flancs de la grille et de sorte à modifier uniquement une portion supérieure de l'épaisseur de la couche à base de nitrure au niveau des flancs de la grille en conservant des portions non-modifiées de la couche à base de nitrure recouvrant les flancs de la grille;- au moins une étape de retrait de la couche modifiée à base de nitrure à l'aide d'une gravure sélective de la couche modifiée à base de nitrure vis-à-vis des portions non-modifiées de la couche à base de nitrure.

La **figure 1b** illustre un premier problème qui est en relation avec la sélectivité insuffisante d'attaque qui existe lors d'une gravure sèche de type CH3F/O2/He entre le nitrure de silicium et le silicium de la couche superficielle 146. Le résultat est qu'une fraction significative de la mince couche superficielle de silicium monocristallin 146 du substrat SOI peut être alors partiellement consommée 147 lors de la gravure anisotrope du nitrure. Comme précédemment mentionné, la couche superficielle 146 est choisie pour être de faible épaisseur afin d'améliorer les caractéristiques électriques des transistors. Elle est typiquement inférieure à 10 nm. L'épaisseur restante 145 peut être très faible. Dans ces conditions l'implantation ionique 105 pour former les zones de source et de drain 110 qui va suivre est susceptible d'être très dommageable pour le silicium monocristallin restant. L'énergie d'implantation des dopants peut être suffisante pour provoquer une amorphisation complète 149 du silicium monocristallin ce qui va alors notamment compromettre l'étape de croissance épitaxiale 112 suivante destinée à former les source/drain surélevés. Comme précédemment mentionné, cette dernière opération est rendue nécessaire en raison de la diminution de taille des transistors afin de pouvoir maintenir les résistances d'accès aux électrodes de source et de drain à des valeurs suffisamment faibles pour ne pas impacter le fonctionnement électrique des transistors. Une croissance à partir d'une couche de silicium partiellement ou totalement rendue amorphe va créer de nombreux défauts dans la couche formée par épitaxie.

La **figure 1c** illustre un autre problème où il n'y a pas consommation significative du silicium de la couche superficielle 146 mais il y a formation de « pieds » 154 au bas des motifs de nitrure de silicium restants sur les flancs de la grille après gravure. La conséquence est que la transition 114 des jonctions qui sont formées après dopage par implantation ionique 105 des zones de source et drain 110, avec la zone du canal 130, est beaucoup moins abrupte que lorsque les espaceurs n'ont pas de pieds comme représenté dans les figures précédentes. La présence de pieds 154 affecte les caractéristiques électriques des transistors. On remarquera ici que la formation ou non de pieds au bas des espaceurs et la consommation ou non de silicium de la couche superficiel de silicium 146 du substrat SOI, décrite dans la figure précédente, sont des paramètres de réglage antagonistes de la gravure qui nécessitent qu'un compromis puisse être trouvé pour lequel, idéalement, on ne forme pas de pieds et on n'attaque pas significativement la couche superficielle de silicium.

La **figure 1d** illustre un troisième problème qui se produit quand la gravure produit une érosion trop importante des espaceurs dans les parties hautes des grilles et met à nu le silicium polycristallin 123 dans ces zones 156. La conséquence est que la croissance épitaxiale 112 ultérieure pour former les source/drain surélevés va aussi se produire à ces endroits, ainsi qu'une siliciuration de contacts parasites, ce qui risque de provoquer des courts circuits entre électrodes. En effet, la gravure des espaceurs demande que le temps de gravure soit ajusté pour graver, par exemple, 150% de l'épaisseur de nitrure déposé. C'est-à-dire que l'on pratique une surgravure de 50% dans cet exemple afin de tenir compte de la non uniformité du dépôt, ou de l'opération de gravure elle-même, au niveau d'une tranche. Ainsi, dans certaines parties de la tranche on pourra constater qu'il y a une surgravure trop prononcée qui met à nu les zones de grille 156. Ce type de défaut est aussi qualifié de « facettage ».

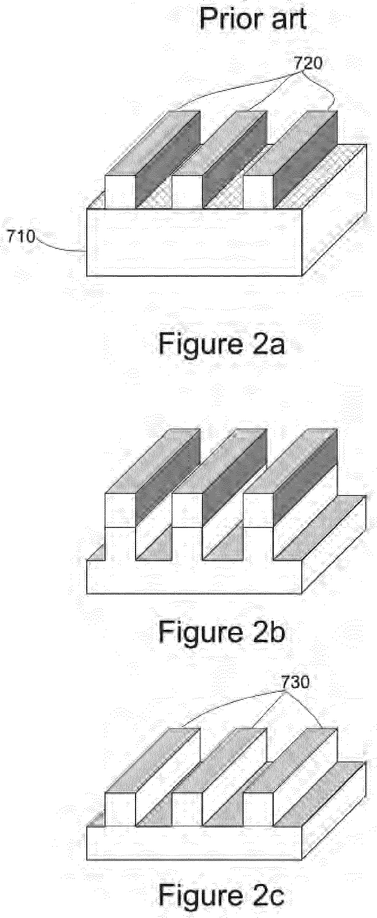

Les **figures 2a à 2i** illustrent comment les problèmes liés à la gravure plasma se posent plus spécifiquement lors de la réalisation de transistors MOSFET de type FinFET, une autre structure de transistor qui commence à être utilisée par l'industrie de la microélectronique pour les noeuds technologiques à partir de celui de 22 nm. Dans la structure FinFET le canal de conduction est constitué d'une mince lamelle verticale de silicium, qualifiée du terme anglais de « fin » c'est-à-dire de « nageoire ». Il est entouré sur trois côtés par la grille de commande. Cela permet notamment d'obtenir des transistors ayant de meilleures performances électriques et aussi de réduire les courants de fuite.

Les figures **2a à 2i** décrivent les étapes principales de formation d'un transistor FinFET et les difficultés rencontrées. Les **figures 2a, 2b et 2c** illustrent plus particulièrement la formation par gravure d'une couche 710 d'un semi-conducteur cristallin, le plus souvent du silicium, des motifs tridimensionnels, c'est-à-dire les « fins », qui vont former les canaux de conduction 730 des transistors. La forme des canaux est définie par un masque dur 720 qui est transféré par gravure dans la couche 710. Cette couche est par exemple la couche superficielle de silicium monocristallin d'un substrat SOI déjà décrit et repose donc sur une couche continue d'oxyde et un substrat (non représentés).

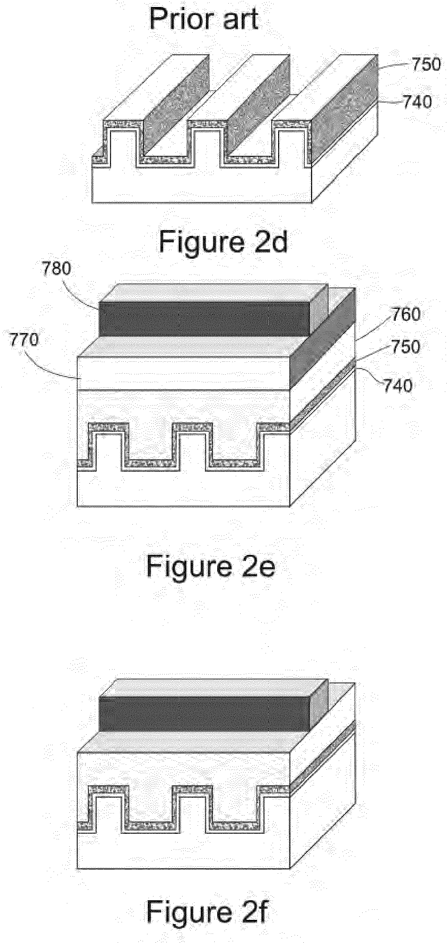

Les **figures 2d, 2e et 2f** illustrent la formation de la grille des transistors. Comme avec les transistors de type FDSOI la grille est constituée d'un empilement de couches que l'on vient successivement déposer sur les motifs 730 qui vont constituer les canaux. On retrouve donc la fine couche isolante d'oxyde de grille 740 et la couche 750 faite d'un matériau isolant à haute permittivité (high-k) couverte par une grille métallique (metal gate). Le tout est recouvert par une couche de silicium polycristallin 760 qui a été aplanie et sur laquelle on dépose et définit par photolithographie les masques durs 770 et 780 qui vont permettre par gravure de l'empilement des couches ci-dessus de former la grille ainsi que les électrodes source et drain des transistors.

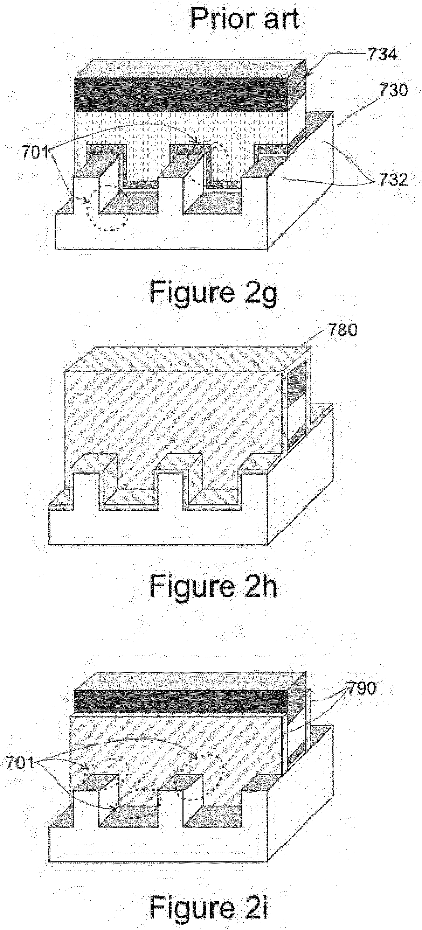

Les **figures 2g, 2h et 2i** illustrent les opérations suivantes où l'on procède à la gravure des couches de grille ce qui permet de libérer, à partir de chaque motif 730, les zones de source et de drain 732 de part et d'autre de la grille et de définir la longueur des canaux 734. Comme avec les transistors de type FDSOI on a aussi besoin d'espaceurs. Ils sont obtenus, après dépôt d'une couche continue 780 faite généralement de nitrure de silicium, à l'aide d'une gravure très anisotrope de cette couche qui ne laisse en place que les motifs verticaux 790 sur les flancs de la grille.

Comme les transistors FDSOI, les transistors de type FinFET souffrent donc pour leur réalisation des limitations et imperfections de la gravure plasma. En particulier, pour réaliser cette structure de transistor, la gravure utilisée doit avoir une excellente sélectivité vis-à-vis du silicium (Si) et de son oxyde (SiO2) ce qui est difficile à obtenir, comme on l'a vu, avec une gravure plasma. Comme indiqué sur les **figures 2g et 2i** l'intégrité des angles des motifs gravés en est affectée. En effet, pour que le transistor FinFET présente de bonnes performances, les arêtes 701 des « fins » doivent former des angles qui soient les plus droits possible, tout arrondi de ces angles entraînant une réduction des performances du transistor. Il en est de même pour l'angle que forme les espaceurs et la couche sur laquelle elle repose, typiquement la couche de silicium. Cet angle est indiqué en pointillé sur la **figure 2i****.**

Pour les raisons indiquées ci-dessus, les solutions actuelles reposant sur les gravures plasma ne permettent pas d'obtenir des arêtes formant des angles droits.

On voit donc que la gravure plasma, si elle a permis de suivre les réductions de taille des motifs à chaque introduction d'un nouveau noeud technologique dans les années passées, pose cependant de plus en plus de problèmes quand la taille diminue, en particulier au-delà du noeud technologique de 22 nm. La mise en oeuvre de la gravure plasma pour ces dimensions introduit un degré de complexité supplémentaire pour essayer de pallier les problèmes décrits ci-dessus. Des chimies de gravure plus complexes que celle traditionnelle, dite fluorocarbonée, ont été testées qui nécessitent d'introduire des gaz supplémentaires dans la chambre de gravure. Jusqu'à cinq gaz différents ont été combinés pour former le plasma de gravure. Cela a pour conséquence première de complexifier considérablement le procédé.

Le caractère tridimensionnel (3D) de la structure FinFET fait que les problèmes exposés précédemment pour la réalisation des transistors de type FDSOI se posent avec encore plus d'acuité pour la réalisation des FinFET. On notera par ailleurs que la réalisation de cette structure demande que l'on ait recours non seulement à une gravure anisotrope pour la réalisation des espaceurs 790 sur les flancs des électrodes de grille mais que l'on puisse également graver les flancs des électrodes source/drain 732 en ayant recours à une gravure isotrope.

De plus, pour certaines applications il peut être nécessaire de prévoir une couche de protection souvent à base de carbone telle un masque ou une résine photosensible (de l'anglais « photoresist ») ou thermosensible afin de protéger lors de la gravure des espaceurs des structures formées sur le substrat. Tel est par exemple le cas lors de la réalisation de transistors PMOS proches de transistors NMOS dont les espaceurs sont en cours de réalisation. Les procédés connus de gravure peuvent conduire à une forte consommation de cette couche de protection lors de la gravure des espaceurs du transistor PMOS.

La présente invention a pour objet de proposer un procédé de formation d'espaceurs jouant pleinement leur rôle d'isolation et qui supprimerait ou limiterait au moins certains des défauts dans la réalisation de transistors, tels que la consommation du matériau semi-conducteur (i.e. Si, SiGe) de la couche active, la formation de « pieds » au bas des motifs sur les flancs de la grille d'un transistor, la consommation d'une couche de protection à base de carbone etc.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de formation des espaceurs d'une grille d'un transistor à effet de champ, la grille étant située au-dessus d'une couche active en un matériau semi-conducteur, comprenant : une étape de formation d'une couche à base de nitrure recouvrant la grille dudit transistor ; au moins une étape de modification de la couche à base de nitrure, réalisée après l'étape de formation de la couche à base de nitrure, par mise en présence de la couche à base de nitrure avec un plasma comprenant des ions plus lourds que l'hydrogène et du CxHy où x est la proportion de carbone et y est la proportion d'hydrogène pour former une couche modifiée à base de nitrure et former un film carboné.

L'étape de modification est réalisée de manière à ce que le plasma provoque un bombardement anisotrope d'ions à base d'hydrogène provenant du CxHy selon une direction privilégiée parallèle à des flancs de la grille et de sorte à modifier uniquement une portion supérieure de l'épaisseur de la couche à base de nitrure au niveau des flancs de la grille en conservant des portions non-modifiées de la couche à base de nitrure recouvrant les flancs de la grille.

Les ions à base d'hydrogène sont de préférence pris parmi : H, H⁺, H₂⁺, H₃⁺.

Un film carboné est un film comprenant des espèces chimiques contenant du carbone. Selon un mode de réalisation non limitatif le film carboné est en carboné.

L'étape de modification est réalisée de manière à former un film carboné notamment sur des surfaces parallèles à la direction du bombardement.

Le procédé comprend également au moins une étape de retrait de la couche modifiée à base de nitrure à l'aide d'une gravure sélective de la couche modifiée à base de nitrure vis-à-vis dudit film carboné et vis-à-vis des portions non-modifiées de la couche à base de nitrure.

Lesdites portions non-modifiées peuvent ainsi constituer les espaceurs pour la grille.

De manière particulièrement avantageuse, il a été constaté que le bombardement d'ions plus lourds que l'hydrogène tels que l'He permet aux espèces chimiques du plasma contenant du carbone provenant du CxHy de former un film protecteur de carbone (film carboné) notamment sur des surfaces parallèles à la direction du bombardement et empêche par ailleurs à ces espèces chimiques contenant du carbone de former un film carboné sur les surfaces de la couche à base de nitrure qui sont perpendiculaires à la direction du bombardement.

Le bombardement d'ions plus lourds que l'hydrogène détruit en effet le film de carbone qui aurait tendance à se déposer sur les surfaces perpendiculaires à la direction du bombardement.

Lors de l'étape de retrait, cette gravure grave les surfaces de la couche modifiée à base de nitrure qui ne sont pas recouvertes du film carboné.

Ainsi, il est possible de protéger une structure sur laquelle le film carboné se forme.

En outre, il a été constaté que le bombardement ionique n'empêche pas la formation de ce film carboné lorsque lorsqu'on met en présence une couche comportant du carbone avec le plasma. Ce film carboné fait alors office de film de protection qui empêche la modification de la couche carbonée recouverte par le film. Par ailleurs, la gravure étant sélective du nitrure modifiée par rapport au carbone, le film carboné formé sur la couche carbonée protège cette dernière lors de l'étape de retrait.

De manière particulièrement avantageuse, la modification de la couche à base de nitrure par bombardement d'ions hydrogène (H) conduit à implanter ces ions à base d'hydrogène dans les couches visées. Cette modification par implantation d'ions permet d'améliorer considérablement la sélectivité de cette couche par rapport au matériau semi-conducteur, typiquement du silicium. Cette implantation fait également que l'épaisseur de nitrure modifiée se grave plus rapidement que le nitrure non modifiée.

La gravure consomme ainsi la couche modifiée à base de nitrure préférentiellement à la couche de matériau semi-conducteur et aux portions non modifiées de la couche à base de nitrure. Ainsi, le risque de consommation excessive de la couche superficielle de matériau semi-conducteur est réduit voir supprimé.

De préférence, la modification de la couche à base de nitrure conserve une épaisseur de nitrure non modifiée sur les flancs de la grille. Cette épaisseur est conservée, au moins en partie, lors de la gravure sélective. Elle définit alors des espaceurs de grille.

L'invention permet ainsi d'obtenir des espaceurs de nitrure tout en réduisant voire en éliminant les problèmes des solutions connues et mentionnés précédemment. En particulier, si une couche ou un bloc comprenant du carbone est présente. Cette couche à base de carbone n'est pas consommée par la gravure. Il peut par exemple s'agir d'un masque dur de carbone. Il peut également d'agir d'une résine à base de carbone disposée de manière à protéger de la gravure et du plasma une structure réalisée au préalable.

L'implantation réalisée à partir d'un plasma comprenant lesdits ions à base d'hydrogène a pour avantage de permettre une implantation de manière continue dans un volume s'étendant dès la surface de la couche implantée.

En outre l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

L'implantation plasma permet typiquement d'implanter puis de retirer des épaisseurs s'étendant depuis la surface de la couche implantée et sur une profondeur allant de 0 nm à 100 nm. Les implanteurs classiques, permettent une implantation dans un volume compris entre 30 nm et plusieurs centaines de nanomètres. En revanche, les implanteurs classiques ne permettent pas d'implanter les espèces entre la surface de la couche à implanter et une profondeur de 30 nm. Dans le cadre du développement de la présente invention, il a été remarqué que les implanteurs ne permettent alors pas d'obtenir une vitesse de gravure suffisamment constante de la couche modifiée et ce depuis la surface de cette dernière, conduisant ainsi à une moindre précision de gravure comparé à ce que permet l'invention.

L'utilisation d'un plasma pour modifier la couche à retirer est donc particulièrement avantageuse dans le cadre de l'invention qui vise à retirer une fine épaisseur de nitrure, typiquement comprise entre 1 et 10 nm et plus généralement entre 1 et 30 nm.

L'étape de modification réalisée à partir d'un plasma modifie la couche à base de nitrure de manière continue depuis la surface de la couche à base de nitrure et sur une épaisseur comprise entre 1 nm et 30 nm et de préférence entre 1 nm et 10 nm.

De manière également avantageuse, la modification de la couche à base de nitrure par implantation d'ions à base d'hydrogène permet également d'améliorer la sélectivité de cette couche modifiée à base de nitrure par rapport à l'oxyde du matériau semi-conducteur. Typiquement, dans le cas d'un transistor FinFET, la couche modifiée à base de nitrure est retirée des fins alors que l'oxyde de grille n'est pas consommé ou est moins consommé.

Ainsi, lors de l'étape de modification les conditions du plasma, en particulier la concentration en CxHy, l'énergie des ions et la direction principale d'implantation sont choisies de manière à ce que :
∘ le plasma créé un bombardement d'ions à base d'hydrogène (H) provenant de CxHy anisotrope selon une direction privilégiée parallèle à des flancs de la grille et de sorte à modifier uniquement une portion supérieure de l'épaisseur de la couche à base de nitrure au niveau des flancs de la grille en conservant des portions non-modifiées) de la couche à base de nitrure recouvrant les flancs de la grille,
∘ des espèce chimiques du plasma contenant du carbone provenant du CxHy forment un film carboné notamment sur des surfaces parallèles à la direction du bombardement ;
∘ le plasma créé un bombardement des ions plus lourds que l'hydrogène qui empêche aux espèces chimiques contenant du carbone provenant du CxHy de former un film carboné notamment sur les surfaces de la couche à base de nitrure qui sont perpendiculaires à la direction du bombardement;

Sont énoncées ci-après des caractéristiques optionnelles qui peuvent éventuellement être utilisées en association ou alternativement avec les caractéristiques ci-dessus:
Le bombardement d'ions plus lourds que l'hydrogène (désignés par la suite « ions lourds »), en particulier son énergie, sa direction et sa fluence sont prévues de sorte que le film carboné se forme sur les surfaces parallèles à la direction d'implantation et de sorte que le film carboné ne se forme pas sur les surfaces de la couche à base de nitrure qui sont perpendiculaires à la direction d'implantation. Plus précisément, le bombardement ionique consomme, de manière très anisotrope, les espèces chimiques contenant du carbone qui se déposent sur le fond des structures. Le bombardement suivant une direction perpendiculaire à la direction d'implantation (c'est-à-dire au niveau des flancs) est très faible. L'énergie des ions n'est donc pas suffisante pour empêcher la formation de ce film carboné.

De manière avantageuse mais non limitative, le procédé comprend, préalablement à l'étape de modification et de préférence après l'étape de formation de la couche à base de nitrure, une étape de dépôt d'une couche comprenant du carbone.

Le film carboné agit comme un film de protection pour la couche de carbone empêchant ou réduisant la modification de cette dernière sous l'effet du bombardement ionique. La couche de carbone n'est ainsi pas ou que peu modifiée lors de l'étape de modification.

Cette couche comprenant du carbone est distincte du transistor pour lequel on réalise les espaceurs.

Cette couche comprenant du carbone forme par exemple un bloc de masquage d'une structure réalisée au préalable.

Il s'est avéré qu'en sélectionnant l'énergie des ions et la densité de CxHy la couche de carbone n'est pas sensiblement modifiée par l'implantation des ions plus lourds que l'hydrogène même sur ses surfaces perpendiculaires à la direction privilégiée du bombardement. Il s'est avéré que le carbone provenant du CxHy réagit avec le carbone de la couche comprenant du carbone pour former en surface une couche de carbone suffisamment épaisse et dense pour résister au bombardement d'ions, et ceci même sur les surfaces de la couche de carbone qui sont perpendiculaires à la direction privilégiée du bombardement.

Plus précisément, en raison des affinités chimiques entre la couche comprenant du carbone et le carbone du plasma, ce dernier ce dépose sur la couche comprenant du carbone rapidement et avant d'être pulvérisé. Ces affinités chimiques permettent d'atteindre un régime de dépôt rapidement et la couche comprenant du carbone n'est ainsi pas consommée.

Ainsi, le film carboné formé sur les flancs de la grille n'empêche pas la modification du film de nitrure sous l'effet du bombardent ionique alors que le film carboné formé sur les parois de la couche comportant du carbone empêche la modification de cette couche sous l'effet de ce même bombardement ionique.

Ainsi l'invention est particulièrement avantageuse pour réaliser des structures différentes sur un même substrat, par exemple un transistor NMOS adjacent à un transistor PMOS.

De préférence, la couche comprenant du carbone est une couche de résine photosensible ou thermosensible. Un transistor NMOS par exemple peut être recouvert d'une résine à base de carbone tandis qu'un transistor PMOS n'est pas recouvert par la résine. La résine protège le transistor NMOS lors de l'étape de modification et de gravure de la couche à base de nitrure du transistor PMOS.

Dans un autre mode de réalisation, cette couche comprenant du carbone est un masque dur de préférence formé de carbone.

Dans un mode de réalisation avantageux, ladite couche comprenant du carbone est configurée pour recouvrir une structure distincte dudit transistor, ladite structure et le transistor étant sur un même substrat.

De préférence, ladite structure est située au-dessus de ladite couche active en un matériau semi-conducteur.

De préférence, ledit transistor est un transistor NMOS et ladite structure est un transistor PMOS. Dans un autre mode de réalisation préféré, ledit transistor est un transistor PMOS et ladite structure est un transistor NMOS.

Préférentiellement, lors de l'étape de modification réalisée par mise en présence de la couche à base de nitrure avec le plasma comprenant du CxHy, le film carboné recouvre les parois de la couche comprenant du carbone, l'épaisseur e2 du film carboné recouvrant les parois de la couche comprenant du carbone étant supérieure à l'épaisseur e1 du film carboné au niveau des flancs de la grille.

Ainsi le film carboné d'épaisseur e2 résiste au bombardement des ions, ce qui permet de protéger la couche comprenant du carbone lors de l'étape de modification ainsi que lors de l'étape de retrait. De plus, l'étape de retrait ne donc conduit pas à une consommation de la couche comprenant du carbone.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURE 1a à 1d montrent, d'une part, une vue en coupe d'un exemple de transistor MOSFET de type FDSOI en cours de réalisation et, d'autre part, illustrent différents défauts qui peuvent être observés sur des structures de transistors FDSOI lors de la gravure des espaceurs en utilisant l'un ou l'autre des procédés standard de gravure anisotrope développés par l'industrie de la microélectronique.
Les FIGURES 2a à 2i illustrent la structure tridimensionnelle (3D) d'un exemple de transistor MOSFET de type FinFET et les problèmes de gravure qui se posent dans ce cas.
La FIGURE 3 résume les principales étapes d'un exemple de procédé de formation des espaceurs d'un transistor selon l'invention appliqué à la réalisation de transistors.
Les FIGURES 4a à 4d illustrent les structures d'un transistor obtenues à l'issue des certaines des étapes du procédé selon un mode de réalisation de l'invention.
Les FIGURES 5a, 5b et 5e illustrent respectivement une structure d'un transistor obtenue à l'issue d'une des étapes du procédé selon un autre mode de réalisation de l'invention. Les FIGURES 5a, 5c à 5e illustrent respectivement une structure d'un transistor obtenue à l'issue d'une des étapes du procédé selon un mode de réalisation différent des deux modes de réalisation illustrés précédemment.
La FIGURE 6 illustre les étapes du retrait par voie sèche de la couche modifiée.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas représentatives de la réalité.

### DESCRIPTION DÉTAILLÉE DE L'INVENTION

Il est précisé que dans le cadre de la présente invention, le terme « sur », « surmonte », « recouvrir » ou « sous jacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

Avant d'entamer une revue détaillée de modes de réalisation de l'invention, sont énoncées ci-après des caractéristiques optionnelles qui peuvent éventuellement être utilisées en association ou alternativement :
De manière avantageuse, le CxHy est du CH4.

Les ions plus lourds que l'hydrogène du plasma, pris parmi l'argon (Ar), l'hélium (He), l'azote (N2), le xénon (Xe) et l'oxygène (02), peuvent être utilisés alternativement ou être combinés dans un même plasma. Leur rôle est d'empêcher la formation du film carboné dans le fond du motif. D'autres ions peuvent convenir.

Les ions à base d'hydrogène sont de préférence pris parmi : H, H⁺, H₂⁺, H₃⁺.

La couche à base de nitrure est préférentiellement une couche de nitrure de silicium.

L'étape de retrait de la couche modifiée à base de nitrure, est de préférence effectuée par gravure humide sélective au carbone, au nitrure des portions non-modifiées de la couche à base de nitrure, et/ou audit matériau semi-conducteur de la couche active et/ou à l'oxyde de silicium (SiO2). Dans ce cas, la couche modifiée de nitrure est consommée très facilement par rapport à la consommation du carbone, du matériau semi-conducteur de la couche active (typiquement du silicium) et/ou de l'oxyde de silicium (SiO2).

En effet, les solutions prévoit une solution de gravure à base d'acide fluorhydrique (HF) qui consomme le nitrure à une vitesse de 0.5 nm/minute et avec une sélectivité du nitrure par rapport au silicium de l'ordre de 20 à 30.

De plus, la sélectivité du nitrure modifié par rapport au carbone et au nitrure non-modifié est respectivement supérieure à 100 et à 30.

Cela permet donc d'améliorer considérablement la sélectivité et donc la précision de la gravure.

On évite ainsi de consommer de manière excessive la couche active et la couche comprenant du carbone, de découvrir les flancs de la grille ou de former des pieds.

D'autres caractéristiques optionnelles de l'invention, qui peuvent être mises en oeuvre de façon combinée selon toutes combinaisons ou de manière alternative, sont indiquées ci-après :
- Avantageusement, l'étape de modification est réalisée de manière à ce que le plasma génère un bombardement des ions plus lourds que l'hydrogène de manière anisotrope selon une direction privilégiée parallèle aux flancs de la grille de sorte à empêcher au carbone provenant du CxHy de former un film carboné sur les surfaces perpendiculaires aux flancs de la grille.
- Avantageusement, l'étape de modification est réalisée de manière à ce que les ions plus lourds que l'hydrogène du plasma dissocient la molécule du CxHy de sorte à permettre aux ions à base d'hydrogène provenant du CxHy de s'implanter dans ladite portion de la couche à base de nitrure. Ainsi, les ions à base d'hydrogène provenant de la molécule CxHy sont dissociés par les ions lourds du plasma. Il s'est avéré que l'hélium (He) est particulièrement efficace pour obtenir cette dissociation du CxHy. Le mélange comprend ainsi un mélange CxHy/He.
- Avantageusement, l'étape de retrait de la portion modifiée à base de nitrure est effectuée par gravure sélectivement à la couche active.
- Avantageusement, lors de l'étape de modification les conditions du plasma, en particulier la concentration en CxHy, l'énergie des ions et la direction principale d'implantation sont choisies de manière à ce que, au niveau des surfaces perpendiculaires à la direction d'implantation, tout l'épaisseur de la couche à base de nitrure soit modifiée par l'implantation des ions à base d'hydrogène et dans lequel l'étape de retrait est réalisée de manière à retirer toute la couche modifiée, mettant ainsi à nu la couche active au niveau des surfaces perpendiculaires à la direction d'implantation.
- Avantageusement, l'épaisseur e2 du film carboné recouvrant les parois de la couche comprenant du carbone est deux fois supérieure à l'épaisseur e1 du film carboné au niveau des flancs de la grille.
- Alternativement, l'étape de retrait est effectuée par gravure sèche sélective de ladite couche modifiée à base de nitrure vis-à-vis dudit film carboné, vis-à-vis des portions non-modifiées de la couche à base de nitrure et vis-à-vis dudit matériau semi-conducteur. En outre la gravure sèche ne prélève pas non plus l'oxyde de silicium (SiO2) formant un masque dur au sommet de la grille.
- De préférence, le matériau semi-conducteur est du silicium, et l'étape de retrait de la couche modifiée à base de nitrure est effectuée par gravure sèche sélective au silicium (Si).
- Préférentiellement, la gravure sèche est effectuée dans un plasma formé dans une enceinte confinée à partir de trifluorure d'azote (NF3) et d'ammoniac (NH3).
- Selon un mode de réalisation particulièrement avantageux, l'implantation et le retrait de la couche à base de nitrure sont réalisées dans un même réacteur plasma. Une modification de la couche à retirer réalisée par une implantation par plasma permet ainsi d'effectuer la modification de la couche et la gravure dans une même chambre ce qui est très avantageux en termes de simplification, de temps et de coût du procédé.
- Avantageusement, la gravure sèche comprend une étape de gravure consistant en la formation de sels solides ; et une étape de sublimation des espèces solides. Ce mode de réalisation permet d'obtenir une très bonne sélectivité de la gravure du nitrure modifié par rapport au nitrure non modifié et au matériau semi-conducteur non modifié. En particulier, cette sélectivité de la gravure est très supérieure (typiquement un facteur 10 au moins) à celle obtenue avec une solution de HF.
- De manière préférentielle mais non limitative, le procédé comprend plusieurs séquences comprenant chacune une étape de modification et une étape de retrait, et dans lequel au cours d'au moins l'une des étapes de modification, seule une partie de l'épaisseur de la couche à base de nitrure est modifiée.
- Les séquences sont de préférence répétées jusqu'à disparition de la couche modifiée à base de nitrure sur toutes les surfaces parallèles au plan d'un substrat sur lequel repose la grille.
- Dans un mode de réalisation, l'étape de modification est une unique étape effectuée de manière à modifier la couche à base de nitrure dans toute son épaisseur sur toutes les surfaces parallèles au plan d'un substrat sur lequel repose la grille et à ne pas modifier la couche à base de nitrure dans toute son épaisseur sur les surfaces perpendiculaires à ce plan. Ce mode de réalisation permet un contrôle particulièrement précis de la dimension des espaceurs.
- De manière préférentielle mais non limitative, l'étape de modification est précédée d'une étape de gravure isotrope qui est effectuée dans un plasma de type CH3F/O2/He. Ce mode de réalisation permet d'enlever beaucoup de nitrure en une étape puis d'affiner le contrôle de l'épaisseur sur les flancs au cours d'une deuxième étape. Ce mode de réalisation permet ainsi de réduire le temps de fabrication.
- La grille du transistor est située sur un empilement de couches formant un substrat élaboré de type silicium sur isolant (SOI).
- Le matériau semi-conducteur est pris parmi: le silicium (Si), le germanium (Ge), le silicium-germanium (SiGe). L'étape de retrait de la couche à base de nitrure de silicium modifiée est effectuée par gravure humide sélectivement au Ge ou au SiGe ou et/ou à de l'oxyde de SiGe ou de l'oxyde de Ge.
- L'étape de modification réalisée à partir d'un plasma modifie la couche à base de nitrure de manière continue depuis la surface de la couche à base de nitrure et sur une épaisseur comprise entre 1 nm et 30 nm et de préférence entre 1 nm et 10 nm.
- Le transistor est un transistor de type FDSOI ou FinFET.

Comme on l'a vu un objet de l'invention est de s'affranchir de tous ou d'au moins certains des problèmes mentionnés ci-dessus.

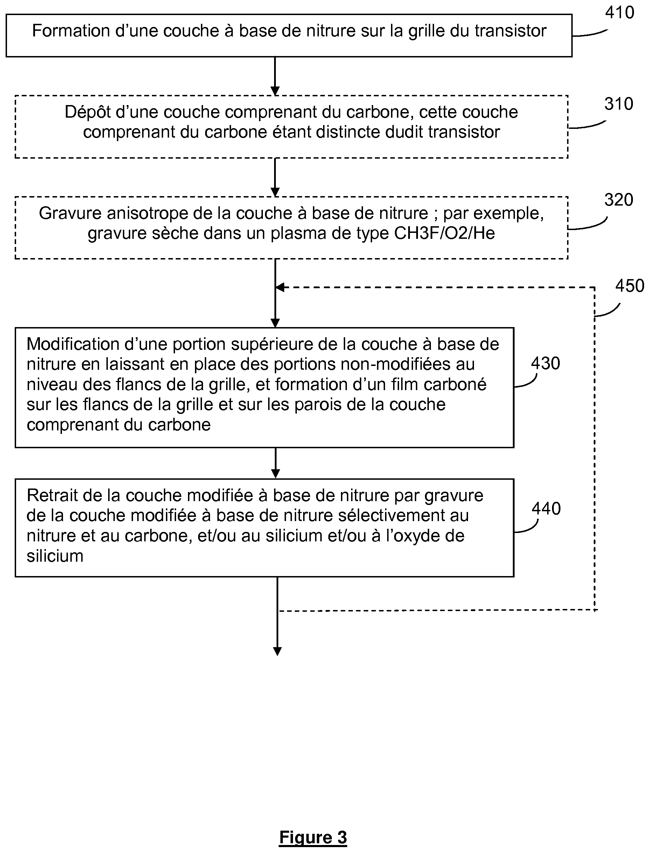

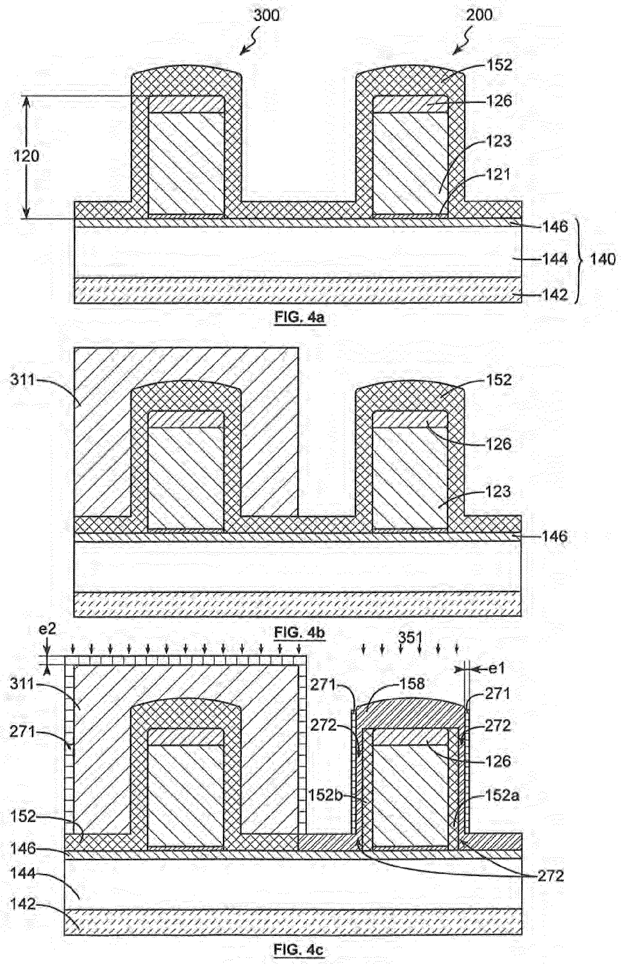

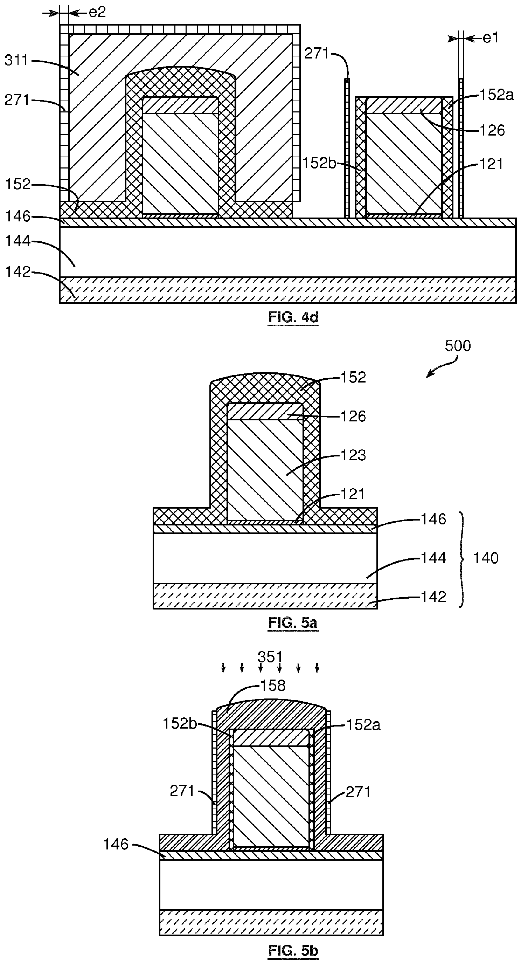

La **figure 3** résume les principales étapes 410 à 440 d'un exemple détaillé d'un procédé de formation des espaceurs d'un transistor selon l'invention. Ces étapes 410 à 440 peuvent également s'appliquer à la formation d'espaceurs sur les flancs des grilles de transistors variés : FDSOI, FinFET, etc. Les étapes 410 à 440 seront respectivement détaillées dans les paragraphes ci-dessous concernant les **figures 4a** à **4d** **et** **5a à 5e** illustrant respectivement une structure d'un transistor 200 obtenue à l'issue d'une des étapes 410 à 440 selon un mode de réalisation de l'invention.

La **figure 4a** illustre une structure obtenue à l'issue de l'étape de formation 410 d'une couche à base de nitrure 152 recouvrant un transistor 200 formé sur un substrat 140 de type SOI comprennent une couche active 146 surmontée d'une grille 120 du transistor 200.

La formation du transistor 200 consiste à réaliser un substrat élaboré 140 de type SOI, à partir d'un substrat 142, souvent désigné substrat massif (bulk substrat en anglais), une couche isolante initiale 144 et la couche active 146, cette dernière étant destinée à former ultérieurement un canal de conduction du transistor 200.

En plus d'une couche de silicium polycristallin 123 on retrouve dans un empilement des couches formant la grille 120 tout d'abord une mince couche isolante d'oxyde de grille 121 à travers laquelle un champ électrique va pouvoir se développer pour créer un canal de conduction sous jacent entre source et drain quand une tension électrique suffisante est appliquée sur la grille 120. Dans les transistors MOSFET les plus récents il est mis en oeuvre une technologie qualifiée du vocable anglais de « high-k/metal gate » c'est-à-dire que la couche diélectrique 121 est faite d'un matériau isolant à haute permittivité (high-k) couverte par une couche métallique (metal gate ; non-illustrée en figures) de la grille 120. À ce stade, l'empilement de couches de la grille 120 comprend aussi un masque dur 126 de protection qui sera enlevé ultérieurement pour permettre la reprise de contact sur cette électrode. Ce masque dur 126, qui reste en place après gravure de la grille, est typiquement fait d'oxyde de silicium (SiO2). Son rôle est de protéger le sommet de la grille 120 de tout dommage lors de la réalisation des étapes suivantes et notamment celles de gravure des espaceurs.

De préférence, la couche diélectrique 121 est disposée au contact de la couche active 146 formant le canal de conduction. De préférence, la couche métallique est disposée au contact de la couche diélectrique 121. De préférence, la couche de silicium polycristallin 123 est disposée directement au contact de l'oxyde de grille formée par la couche diélectrique 121 si la couche métallique est absente ou est disposée directement au contact de la couche métallique.

De manière préférentielle mais non limitative, une structure 300 distincte du transistor 200 est formée, préalablement à l'étape de formation 410 de la couche à base de nitrure 152, sur le substrat 140 sur lequel repose la grille 120.

Dans le cadre de l'invention, la présence de cette structure 300 est facultative.

Dans cet exemple, et sans que cela ne soit limitatif, le transistor 200 est un transistor NMOS et la structure 300 est un transistor PMOS. Dans un autre mode de réalisation, le transistor 200 est un transistor PMOS et la structure 300 est un transistor NMOS.

L'étape de formation 410 de la couche à base de nitrure 152, d'épaisseur préférentiellement sensiblement constante, est effectuée de manière à recouvrir le transistor 200 et la structure 300, c'est-à-dire sur toutes les surfaces, verticales et horizontales, des dispositifs en cours de fabrication. Il s'agit ainsi d'un dépôt que l'on peut qualifier de conforme. De manière préférentielle mais non limitative, la couche à base de nitrure 152 est disposée directement au contact des surfaces des structures en cours de fabrication.

Cette étape de formation 410, qui n'est pas différente de l'étape correspondante des procédés connus et qui a déjà été mentionnée en figure 1a, se fait de préférence à l'aide d'une méthode de dépôt dite LPCVD, acronyme de l'anglais « low pressure chemical vapor déposition », c'est-à-dire « dépôt chimique en phase vapeur à faible pression ». Ce type de dépôt qui se pratique à pression atmosphérique permet en effet un dépôt uniforme sur toutes les surfaces quelle que soit leur orientation.

La couche à base de nitrure 152 est de préférence une couche de nitrure de silicium d'un composé chimique Si3N4 ou SiN.

L'épaisseur de la couche à base de nitrure 152 est de préférence suffisamment importante, pour que après la réalisation des étapes de modification 430 et de retrait 440, il reste des portions non-modifiées 152a, 152b de la couche à base de nitrure 152 au niveau des flancs de la grille 120.

Dans un mode de réalisation préféré, l'épaisseur de la couche à base de nitrure 152 est comprise entre 5 nm et 30 nm, de préférence 10 nm.

La **figure 4b** illustre la structure du transistor 200 à l'issue d'une étape facultative de dépôt 310 d'une couche 311 comprenant du carbone, cette couche 311 comprenant du carbone étant distincte dudit transistor 200.

Dans un mode de réalisation préférentiel, la couche 311 comprenant du carbone est configurée pour recouvrir la structure 300 distincte dudit transistor 200, la structure 300 et ledit transistor 200 étant sur le même substrat 140. Cette couche 311 comprenant du carbone peut faire office de protection pour la structure qu'elle recouvre.

De préférence, la couche 311 comprenant du carbone est une couche de résine photosensible ou thermosensible. Dans un autre mode de réalisation, la couche 311 comprenant du carbone est un masque dur comprenant du carbone et de préférence formé de carbone.

La **figure 4c** illustre la structure du transistor 200 à l'issue de l'étape de modification 430 de la couche à base de nitrure 152 et de formation d'un film carboné 271.

L'étape de la modification 430 de la couche à base de nitrure 152 telle que formée à l'issue de l'étape 410, se fait par mise en présence de la couche à base de nitrure 152 avec un plasma comprenant des ions plus lourds que l'hydrogène et du CxHy où x est la proportion de carbone et y est la proportion d'hydrogène et d'ions plus lourds que l'hydrogène, afin de former une couche modifiée 158 à base de nitrure et un film carboné 271.

Ainsi, les espèces du plasma remplissent trois fonctions au moins. Ces trois fonctions seront expliquées en détail dans la description ci-dessous.
« a » dépôt d'une couche protectrice formée du film carboné 271, sur les flancs de la grille 120 et sur la couche 311 comprenant du carbone lorsqu'elle est présente ;
« b » empécher la formation du film carboné 271 sur les surfaces perpendiculaires aux flancs de la grille 120 ;
« c » modification de la couche à base de nitrure 152 dans toute son épaisseur ou sur une épaisseur importante sur les surfaces perpendiculaires aux flancs de la grille 120 et modification de la couche à base de nitrure 152 dans une moindre épaisseur sur les flancs de la grille 120.

Le plasma utilisé dans l'étape de modification 430 comprend de préférence du méthane (CH4) afin de réaliser les fonctions « a » et « c ». Les espèces chimiques du plasma contenant du carbone provenant du CH4 ou plus généralement du CxHy assurent la fonction « a ». Pour remplir les fonctions « b », le plasma comprend des ions plus lourds que l'hydrogène tels que l'hélium (He), l'argon (Ar), l'azote (N2), le xénon (Xe) et l'oxygène (02). Par souci de concision, ces ions sont désignés dans la suite de la description « ions lourds ».

La fonction « c » est assurée par les ions à base d'hydrogène, typiquement l'ion hydrogène (H). Ces ions ont pour propriété de pénétrer facilement et en profondeur dans la couche à base de nitrure 152. Ils modifient ainsi la couche à base de nitrure 152 mais sans la pulvériser. Les ions lourds pénètrent beaucoup moins profondément dans la couche à base de nitrure 152. Ces ions lourds restent localisés en surface et ne sont donc pas aptes à modifier une épaisseur importante, et a fortiori toute l'épaisseur, de la couche à base de nitrure 152. La profondeur de pénétration des ions lourds est environs dix fois plus faible que la profondeur de pénétration des ions hydrogène.

Plus précisément, les ions à base d'hydrogène peuvent être implantés dans le matériau à graver, sans provoquer de dislocation de sa structure atomique telle qu'elle entraînerait une pulvérisation de ce dernier, et donc sans redépôt du matériau gravé sur les parois du réacteur ou les motifs en cours de gravure eux-mêmes, sont susceptibles de convenir.

Une fonction additionnelle est assurée par les ions lourds. Cette fonction additionnelle consiste à dissocier la molécule CxHy afin de libérer l'espèce H. L'hélium (He) est particulièrement efficace pour assurer cette fonction. Le mélange introduit dans le réacteur plasma comprend ainsi de préférence un mélange CxHy/He.

On notera ici que cette étape de modification 430 de la couche à graver peut se pratiquer de nombreuses façons différentes en adaptant toutes sortes de moyens couramment employés par l'industrie de la microélectronique. On utilise notamment des gravures standard dont lesquels on peut développer des plasmas à faible ou haute densité et où on peut contrôler l'énergie des ions pour permettre l'implantation des espèces légères ci-dessus destinées à modifier la couche à graver. On peut aussi utiliser un type de plasma dit par immersion couramment utilisé pour pratiquer une implantation d'espèces en surface d'un dispositif en cours de fabrication.

Une modification de la couche effectuée par une implantation à l'aide d'un plasma a pour avantage de permettre une implantation en continue depuis la surface libre de la couche à base de nitrure 152 et sur une épaisseur faible, typiquement comprise entre 0 et 100 nm voire entre 0 et 30 nm. Elle permet également de bénéficier d'une sélectivité améliorée dès le début de la gravure et d'une vitesse de gravure constante, conduisant à une précision de gravure améliorée.

L'emploi d'un plasma pour implanter la couche à base de nitrure 152 permet ainsi de retirer une couche très fine de nitrure, typiquement comprise entre 1 et 10 nm et plus généralement entre 1 et 30 nm.

Cette étape de la modification 430 est réalisée pour que le plasma soit anisotrope de manière à bombarder les ions dans une direction 351 privilégiée parallèle aux flancs de la grille 120. Le plasma utilisé lors de cette étape 430 créé un bombardement d'ions à base d'hydrogène (H) provenant de la molécule du CxHy et s'implantant dans une portion supérieure de l'épaisseur de la couche à base de nitrure 152 au niveau des flancs de la grille 120. Ces ions à base d'hydrogène proviennent du CxHy dont la molécule est dissociée par les ions plus lourds que l'hydrogène du plasma.

Les ions à base d'hydrogène sont de préférence pris parmi : H, H⁺, H₂⁺, H₃⁺. Dans la suite de la description, et par souci de concision, on désignera les ions à base d'hydrogène « ions hydrogène ».

Ainsi les ions modifient les surfaces perpendiculaires à la direction du bombardement sur une épaisseur plus importante que les surfaces parallèles à la direction du bombardement. Ainsi la portion supérieure de l'épaisseur de la couche à base de nitrure 152 au niveau des flancs de la grille 120 et modifiée sur une épaisseur moindre que la surface au sommet de la grille 120 et les surfaces de nitrure recouvrant la couche active 146. Une épaisseur de nitrure non modifiée 152a, 152b recouvrant les flancs de la grille 120 est conservée.

Ainsi les ions à base d'hydrogène pénètrent dans la couche à base de nitrure 152 pour la modifier. Dans le même temps le CxHy, de préférence du CH4, du plasma tend à déposer un film carboné 271 sur les différentes parois.

Le bombardement d'ions plus lourds que l'hydrogène permet aux espèces carbonées provenant du CxHy de former le film carboné 271 notamment sur des surfaces parallèles à la direction du bombardement tout en empêchant de former un film carboné 271 sur les surfaces de la couche à base de nitrure 152 qui sont perpendiculaires à la direction 351 du bombardement, tel que le fond des tranchées. En effet, les ions lourds du plasma pulvérisent le les espèces carbonées provenant du CxHy qui aurait tendance à se former sur ces parois perpendiculaires à la direction d'implantation et empêchent donc la croissance de ce film carboné 271 sur ces parois perpendiculaires à la direction d'implantation.

En revanche, sur les surfaces qui reçoivent un bombardement moindre ou qui ne reçoivent pas de bombardement, ce film carboné 271 se forme. Ainsi, il se forme notamment sur les surfaces parallèles à la direction 351 du bombardement.

On notera que de manière particulièrement avantageuse, le film carboné 271 agit comme une couche de protection pour la couche à base de nitrure qu'il recouvre, réduisant l'épaisseur sur laquelle les ions hydrogène pénètrent dans la couche à base de nitrure 152 et modifie cette dernière. Ainsi, le film carboné 271 permet d'augmenter la différence d'épaisseur de modification entre les surfaces recouvertes par le film 271 et les surfaces qui ne le sont pas. On contrôle ainsi encore mieux l'épaisseur gravée.

Dans un mode de réalisation (tel qu'illustré précédemment) utilisant un plasma de He/CH4 de préférence sous forme de mélange, la couche à base de nitrure 152 est modifiée par les ions H venant du gaz de CH4. Les ions He détruisent ou empêchent la formation du film carboné 271 qui aurait tendance à se former sur les surfaces perpendiculaires à la direction 351 telles que les surfaces de la couche modifiée 158 à base de nitrure recouvrant la couche active 146 et le masque dur 126 au sommet de la grille 120.

Dans un autre mode de réalisation utilisant un plasma de H2/CH4/Ar, en plus des ions hydrogène, la nature des ions Argon et les paramètres du plasma, en particulier son énergie, permettent d'assurer une déplétion des groupements méthyles du film carboné 271 réalisée de manière anisotrope, de sorte que le film carboné 271 n'est pas formé sur les surfaces perpendiculaires à la direction 351 telles que ci-dessus.

Ainsi, l'argon permet d'empêcher, éventuellement à lui seul, également la formation du film carboné sur les surfaces perpendiculaires à la direction 351 de bombardement. Combiné à He, N2, Xe et/ou 02 il contribue à pulvériser le film carboné 271 qui aurait tendance à se former.

Ainsi, les ions lourds Ar, He, N2, Xe ou 02 permettent de renforcer l'action des ions à base d'hydrogène en empêchant également la formation du film carboné 271 sur les surfaces perpendiculaires à la direction principale du bombardement.

On notera que dans tous ces modes de réalisation, les ions H du CH4 participent en synergie avec les ions lourds du plasma (He, Ar, N2, Xe ou 02 par exemple) à la modification de la portion 158 de la couche à base de nitrure 152, même si la profondeur de pénétration de ces ions lourds est plus faible que celle des ions à base d'hydrogène.

Ainsi, à l'issue de cette étape de modification 430, le film carboné 271 formé recouvre seulement les surfaces de la couche à base de nitrure 152 qui sont perpendiculaires ou fortement inclinées par rapport au plan du substrat 140, telles que les surfaces supérieures de la couche modifiée 158 à base de nitrure au niveau des flancs de la grille 120 et les parois ou flancs de la couche 311 comprenant du carbone.

On notera que de manière inattendue, le film carboné 271 se forme sur les parois de la couche 311 comprenant du carbone. Les ions du plasma ne pulvérisent pas le film carboné 271 formé sur les parois de la couche 311 comprenant du carbone. Il est probable que cela soit dû aux affinités chimiques et réactions moléculaires entre le carbone de la couche 311 et les espèces chimiques contenant du carbone provenant du CxHy. Cette affinité accélère l'obtention d'un régime de dépôt et favorise la formation du film carboné 271 sur la couche 311 comprenant du carbone. Le film carboné 271 se forme donc rapidement et en dépit du bombardement des ions lourds. Ce film carboné 271 agit ainsi comme une couche de protection pour la couche 311 comprenant du carbone et empêche cette dernière d'être dégradée par le bombardement ionique. Les dimensions de la couche 311 sont donc conservées malgré le bombardement ionique.

En raison des réactions moléculaires ci-dessus, l'épaisseur e2 du film carboné 271 recouvrant les parois de la couche 311 comprenant du carbone est supérieure à l'épaisseur e1 du film carboné 271 sur la couche à base de nitrure 152 (au niveau des flancs de la grille 120). De manière encore plus avantageuse, l'épaisseur e2 du film carboné 271 est au moins deux fois supérieure à l'épaisseur e1 du film carboné 271. Les épaisseurs e1 et e2 apparaissent sur la figure 4c.

L'épaisseur e1 du film carboné 271, mesurée sur un flanc de la grille 120 et perpendiculairement au flanc, est de préférence très fin, par exemple compris entre 1 et 5 nm, de préférence 1 nm.

L'épaisseur e2 du film carboné 271, mesurée sur la couche 311 comprenant du carbone et parallèlement à la direction d'implantation, est de par exemple 5 nm ou compris entre 1 et 10 nm.

Le film de carboné 271 formé sur la couche 311 comportant du carbone est ainsi plus épais que celui sur la couche de nitrure du fait des réactions chimiques entre le carbone de la couche 311 et le carbone apporté par le CxHy du plasma.

L'épaisseur e2 du film carboné 271 formé sur la couche 311 comportant du carbone lui permet de résister au bombardement des ions réalisé de manière anisotrope comme ci-dessus. Ainsi, et de manière surprenante, ce film carboné 271 renforcé ou sur épaissi permet de protéger la couche 311 comprenant du carbone lors de l'étape de modification 430 ainsi que lors de l'étape de retrait 440 et cela même sur les surfaces perpendiculaires à la direction 351 du bombardement.

Ainsi, le film carboné 271 agit comme une couche de protection pour la couche 311 comprenant du carbone, empêchant ou réduisant la modification de cette dernière sous l'effet du bombardement ionique.

Le tableau ci-après donne des conditions typiques de mise en oeuvre de l'étape de modification 430 de la couche à base de nitrure 152, réalisé par utilisation d'un plasma de He/CH4 ou d'un plasma H2/CH4/Ar, en fonction du temps en secondes et la puissance de la polarisation (bias) en watts, etc. Ces conditions sont largement dépendantes de l'épaisseur à modifier de la couche à base de nitrure 152.

| | |
|---|---|
| | plasma à couplage inductif de He/CH4 (He : 50 - 500 sccm, CH4 : 5 - 15 sccm), ou |
| Réacteur de gravure : | plasma de H2/CH4/Ar |
| | (H2 : 50 - 500 sccm, CH4 : 5 - 15 sccm, Ar (Argon) : 100 - 1000 sccm) |
| Épaisseur de la couche à base de nitrure 152 à modifier (épaisseur de la couche modifiée 158 à base de nitrure) : | 1 - quelques dix nm |
| Puissance de la source : | 0 - 2000 Watts |
| Puissance de polarisation (énergie des ions) : | 20 - 500 V |
| Pression : | 5 milli Torr - 10 milli Torr |
| Température : | 10 - 100 °C |
| Temps : | quelques secondes à quelques centaines de secondes |

Un exemple plus précis de mise en oeuvre de l'étape de modification 430 permettant de modifier une épaisseur de 17 mm de nitrure, réalisé par utilisation d'un plasma de He/CH4, est décrit dans le tableau ci-dessous:

| | |
|---|---|
| Réacteur de gravure : | plasma de He/CH4 (He : 250 sccm, CH4 : 10 sccm) |
| Épaisseur de la couche à base de nitrure 152 à modifier (épaisseur de la couche modifiée 158 à base de nitrure): | 17 nm |
| Puissance de la source : | 500 W |
| Puissance de polarisation (énergie des ions) : | 250 V |
| Pression : | 10 milli Torr |
| Température : | 60°C |
| Temps : | 60 secondes |

Préférentiellement, la couche à base de nitrure 152 est modifiée sur toute son épaisseur au-dessus de la grille 120 et au-dessus de la couche active 146 est tout en laissant en place des portions non-modifiées 152a, 152b de la couche à base de nitrure 152 au niveau des flancs de la grille 120.

La **figure 4d** illustre le résultat de l'étape de retrait 440 de la couche modifiée 158 à base de nitrure après que l'on ait procédé à une opération de gravure sélective de la couche modifiée 158 à base de nitrure par rapport : au film carboné 271, aux portions non-modifiée 152a, 152b de la couche à base de nitrure 152 et à la couche active 146.

La solution de gravure grave ainsi la couche modifiée 158 à base de nitrure à laquelle elle a directement accès sur le sommet de la grille 120 et dans le fond des tranchées. La solution de gravure s'introduit également dans l'espace situé au niveau des flancs de la grille 120, entre le film carboné 271 recouvrant les flancs et les portions non-modifiée 152a, 152b. Dans cet espace, occupé par une épaisseur modifiée de nitrure en fin d'étape de modification 430, la solution de gravure consomme la couche modifiée 158 à base de nitrure. Les passages empruntés par la solution de gravure pour consommer cette portion de la couche modifiée 158 sont référencés 272 sur la **figure 4c****.**

En fonction des conditions de gravure, le film carboné 271 recouvrant les flancs de la grille 120 demeure en place ou se désagrège.

Avantageusement, le film carboné 271 d'épaisseur e2 protège la couche 311 comprenant du carbone lors de cette étape de retrait 440.

De plus, la solution de gravure ne consomme avantageusement pas ou que peu de la couche 311 comprenant du carbone. La réalisation de l'étape de retrait 440 ne conduit donc pas à une consommation de la couche 311 comprenant du carbone.

Avantageusement, les paramètres de l'étape de retrait sont également réglés de manière à ce que la couche modifiée 158 à base de nitrure puisse être gravée sélectivement par rapport à une couche faite d'un oxyde typiquement un oxyde dudit matériau semi-conducteur, cette dernière formant par exemple une couche d'oxyde de grille. Typiquement, la gravure sélective de la couche modifiée 158 à base de nitrure ne consomme pas l'oxyde de silicium SiO2.
Avantageusement, ces paramètres sont également réglés de manière à ce que la couche modifiée 158 à base de nitrure puisse être gravée sélectivement par rapport au matériau semi-conducteur de la couche active 146.

Dans un mode de réalisation préférentiel dont la couche modifiée 158 à base de nitrure est de silicium, l'étape de retrait 440 est effectuée par gravure humide en utilisant une solution de gravure à base d'acide fluorhydrique (HF) ou d'acide phosphorique (H3PO4).

Pour éviter les problèmes des procédés conventionnels de gravure des espaceurs décrits dans les **figures 1b à 1d****,** il est nécessaire que la gravure de la couche modifiée 158 à base de nitrure soit la plus sélective possible par rapport au silicium notamment afin de ne pas attaquer le silicium de la couche active 146. Par exemple, dans ce mode de réalisation de gravure humide, il n'y a aucune consommation de silicium de la couche active 146 due à l'utilisation de la solution gravure à base d'acide fluorhydrique (HF).

Comme mentionné ci-dessus, l'épaisseur de la couche modifiée 158 à base de nitrure est typiquement comprise dans une gamme de valeurs allant de 1 nm à quelques dizaines de nm. Les temps de gravure peuvent aller de quelques secondes à quelques minutes en étant évidemment directement dépendants de l'épaisseur qui a été modifiée.

À titre d'exemple, pour enlever une épaisseur modifiée comprise entre 5 nm et 20 nm de nitrure modifié il faut de l'ordre de 30 secondes avec une solution d'acide fluorhydrique (HF) à 1%. Le même temps de gravure est obtenu avec de l'acide phosphorique dilué (H3PO4) à 85%.

L'arrêt de ladite gravure sélective peut donc se faire sur les portions non modifiées 152a, 152b de la couche à base de nitrure 152 ou/et sur le silicium monocristallin de la couche active 146 ou/et encore sur le masque dur 126 au sommet de la grille 120, jusqu'à la disparition de la couche modifiée 158 à base de nitrure.

Pour le retrait de la couche modifiée 158 à base de nitrure, on a de préférence recourt à une gravure humide qui combine le retrait de la couche modifiée 158 à base de nitrure avec un nettoyage humide de la tranche contenant les dispositifs en cours de fabrication, car après cette gravure humide, conventionnellement un nettoyage humide (traduction de l'anglais « wet clean ») est réalisé pour nettoyer un wafer sur lequel est le transistor 200.

De préférence, cette gravure humide est combinée avec le nettoyage humide, ce qui simplifie le procédé et apporte un gain de temps.

Les paramètres du nettoyage humide sont également réglés de manière à ce que la couche modifiée 158 à base de nitrure puisse être gravée très sélectivement par rapport aux espèces contenant du carbone du film carboné 271 notamment recouvrant des parois de la couche 311 comprenant le carbone, et aux portions non-modifiées (les espaceurs obtenus) 152a, 152b de la couche à base de nitrure 152.

Alternativement à une gravure humide, une gravure sèche de la couche modifiée 158 à base de nitrure sélectivement au silicium de la couche active 146, au matériau des espaceurs 152a, 152b, à l'oxyde de silicium (SiO2) du masque dur 126 pourra alors être aussi pratiquée pour cette étape de retrait 440 par voie sèche de la couche modifiée 158 à base de nitrure.

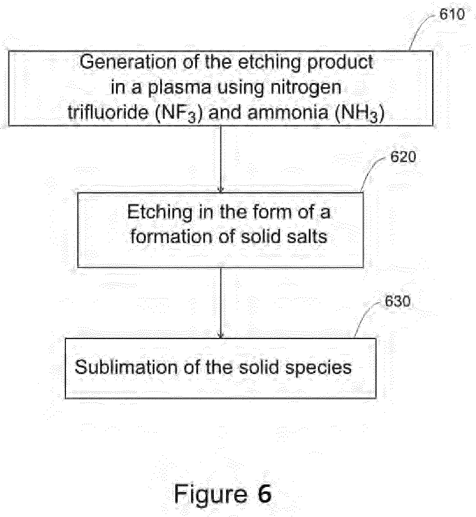

Le principe du retrait par voie sèche de la couche modifiée 158 à base de nitrure comprend les étapes suivantes 610 à 630 illustrées en **figure 6** qui s'effectuent dans une chambre de réaction où l'on forme un plasma. Les épaisseurs traitées sont typiquement comprises entre 1 nm et quelques dizaines de nanomètres.

La méthode est celle décrite par H. Nishini et ses coauteurs dans une publication en anglais intitulée « Damage-free selective etching of Si native oxides using NH3/NF3 and SF6/H2O down flow etching » parue dans le « Journal of Applied Physics » volume 74 (2), en juillet 1993.

Le principe du retrait par voie sèche de la couche de nitrure de silicium est proche de celui décrit dans la publication ci-dessus. La différence est que dans le cas de l'invention on ne grave pas de l'oxyde de silicium mais la couche 158 modifiée par utilisation d'un plasma de type par exemple H2/CH4/Ar.

Le mécanisme est toutefois le même et comprend les étapes suivantes qui s'effectuent dans une chambre de réaction où l'on forme un plasma. Une première étape 610 consiste à générer le produit de gravure dans le plasma selon la réaction chimique suivante :

NF₃+NH₃ → NH₄F + NH₄F.HF

qui fait réagir du trifluorure d'azote (NF₃) avec de l'ammoniac (NH₃).

La gravure se fait au cours d'une deuxième étape 620, à une température de l'ordre de 30°C et plus généralement entre 10°C et 50°C, sous la forme d'une formation de sels selon la réaction chimique suivante :

NH₄F or NH₄F.HF + SiNH → (NH₄)2SiF₆ (solide) + H₂

au cours d'une opération qui dure entre quelques secondes et quelques minutes et qui s'effectue sous une pression comprise entre quelques milli Torr et quelques Torr. Plus précisément, cette opération dure entre 20 secondes et 2 minutes et s'effectue sous une pression comprise entre 500 milli Torr et 3 Torrs.

Les espèces solides qui sont formées au cours de cette opération sont ensuite sublimées 630 à une température supérieure à 100°C pendant quelques dizaines de secondes selon la réaction suivante :

(NH₄)2SiF₆ (solid) → SiF₄(g) + NH₃(g) + HF(g)

Par exemple, pour enlever une couche de 10 nm de nitrure modifié les flux de trifluorure d'azote (NF₃) et d'ammoniac (NH₃) sont respectivement de 50 sccm et de 300 sccm à 30°C pendant 45 secondes pour l'étape 620 de formation des sels qui est suivie par l'étape de sublimation 630 qui s'effectue à 180°C pendant 60 secondes.

Ce mode de réalisation permet d'obtenir une très bonne sélectivité de la gravure du nitrure modifié par rapport au nitrure non modifié et au matériau semi-conducteur non modifié. En particulier, cette sélectivité de la gravure est très supérieure (typiquement un facteur 10 au moins) à celle obtenue avec une solution de HF.

À l'issue de l'étape de retrait 440, il ne reste donc que les portions modifiées 152a, 152b de la couche initiale de nitrure 152 essentiellement sur les flancs de l'empilement de couches qui forment la grille 120. Ces portions non-modifiées 152a, 152b constituent les espaceurs 152a, 152b pour la grille 120 du transistor 200 par exemple de de type FDSOI. De plus, la gravure de la couche modifiée 158 à base de nitrure peut être également réalisée pour la réalisation des espaceurs d'un transistor tridimensionnel de type FinFET.

Le résultat de la **figure 4d** peut être le résultat d'une seule étape de modification et d'une seule étape de retrait ou d'une pluralité de séquence comprenant ces étapes. En effet, les opérations de modification 430 de la couche à base de nitrure 152 et de retrait 440 de la couche modifiée 158 peuvent optionnellement être répétées 450. Les séquences comprenant chacune une étape de modification 430 et une étape de retrait 440 sont réalisées jusqu'à enlèvement complet du nitrure modifié de la couche 158 et disparition du film carboné 271 au niveau des flancs de la grille 120. Le nombre de séquences est calculé en fonction de la vitesse de gravure de la première séquence.

Des étapes additionnelles peuvent par exemple être des étapes standard où l'on réalise possiblement les extensions des zones source/drain par implantation ionique de dopants avant croissance épitaxiale des source/drain surélevés de transistors FDSOI.

Comme mentionné ci-dessus, le mode de réalisation illustré en figures **4a** à **4d** montre la fabrication des espaceurs 152a, 152b du transistor 200 par exemple de type PMOS, sans consommer la couche 311 comprenant du carbone recouvrant la structure 300 tel qu'un transistor de type NMOS, afin d'empêcher la couche 311 comprenant du carbone d'être endommagée par la réalisation des étapes de modification 430 et de retrait 440.

Le procédé de l'invention peut être appliqué pour fabriquer des dispositifs microélectroniques sur un même substrat sur lequel aucun des dispositifs en cours de fabrication n'est recouvert et protégé par une couche de protection telle que la couche 311 comprenant du carbone.

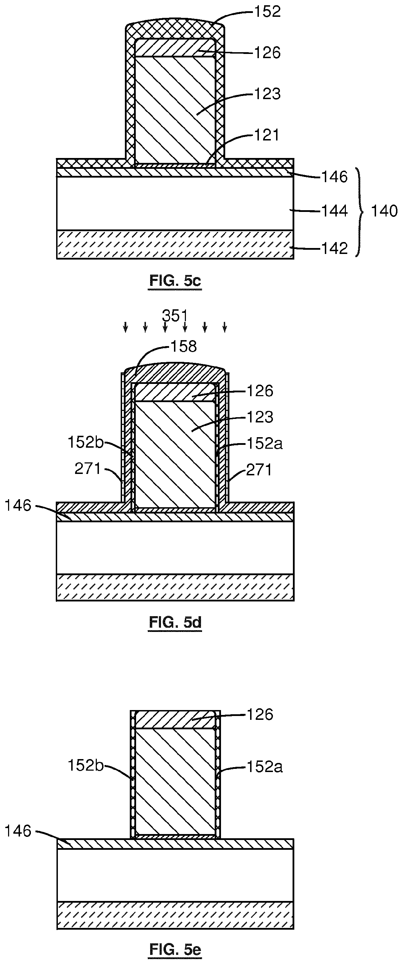

Un mode de réalisation sans dépôt d'une couche 311 comprenant du carbone est illustré en **figures 5a, 5b** et **5e****.**

La **figure 5a** illustre une structure obtenue à l'issue de l'étape de formation 410 d'une couche à base de nitrure 152 recouvrant un transistor 500 formé sur un substrat 140 de type SOI comprennent une couche active 146 surmontée d'une grille 120 du transistor 500.

La structure de départ du transistor 500 est similaire à celle du transistor 200 tel qu'illustrée en **figure 4a****.**

Cette étape de formation 410 n'est pas différente de celle illustrée précédemment en référence au mode de réalisation décrit en figures **4a** à **4d****.**

La description détaillée de la structure de départ du transistor 500 et de l'étape de formation 410 est par conséquent omise afin d'éviter une description redondante.

Dans le présent mode de réalisation, aucune étape de dépôt d'une couche comprenant du carbone n'est réalisée de manière à recouvrir une autre structure formée préalablement sur le substrat 140.

La **figure 5b** montre la structure du transistor 500 obtenue à l'issue de l'étape de modification 430 selon le présent mode de réalisation.

Selon ce mode de réalisation, l'étape de modification 430 est une unique étape effectuée de manière à modifier la couche à base de nitrure 152 dans toute son épaisseur sur toutes les surfaces parallèles au plan du substrat 140 sur lequel repose la grille 120 du transistor 500 et à ne pas modifier la couche à base de nitrure 152 dans toute son épaisseur sur les surfaces perpendiculaires à ce plan.

Le type de plasma utilisé et les conditions de réalisation de mise en oeuvre de cette étape de modification 430 sont similaires à ceux de l'étape 430 du mode de réalisation illustrée précédemment en **figures 4a** à **4d****.**

Ainsi, à l'issue de cette étape de modification 430, le film carboné 271 formé recouvre seulement les surfaces perpendiculaires au plan du substrat 140, telles que les surfaces supérieures de la couche modifiée 158 à base de nitrure au niveau des flancs de la grille 120.

Le film carboné 271 est de préférence très fin, par exemple compris entre 1 et 5 nm, de préférence 1 nm.

Comme le mode de réalisation illustré précédemment en **figures 4a à 4d****,** le film carboné 271 du présent mode de réalisation ne se forme pas sur les surfaces perpendiculaires à la direction 351 du fait du bombardement ionique d'He ou d'Ar réalisé de manière anisotrope.

La **figure 5e** montre la structure finale de l'étape de retrait 440 de la couche modifiée 158 à base de nitrure selon le présent mode de réalisation.

Cette étape de retrait 440 est effectuée pour graver la couche modifiée 158 à base de nitrure par gravure sélectivement aux portions non-modifiées 152a, 152b de la couche à base de nitrure 152, et/ou au matériau semi-conducteur de la couche active 146 et/ou à l'oxyde de silicium (SiO2) du masque dur 126 au sommet de la grille 120. Cette étape de retrait peut être combinée avec une étape standard de nettoyage pour simplifier le procédé, ce qui permet d'apporter un gain de temps.

La gravure est également sélective vis-à-vis des espèces chimiques contenant du carbone, typiquement du carbone, du film carboné 271. Néanmoins, lors de la disparition de la couche modifiée 158 à base de nitrure au niveau des flancs de la grille 120, le film carboné 271 d'épaisseur très fine (par exemple de 1 nm) se désagrège car elle n'est plus supportée.

Le type de gravure sélective et les conditions de réalisation de mise en oeuvre de cette étape de retrait 440 sont similaires à ceux de l'étape 440 du mode de réalisation illustré précédemment en **figures 4a** à **4d****.**

Un autre mode de réalisation sans dépôt d'une couche 311 comprenant du carbone est illustré en figures **5a****,** **5c** à **5e.**

Le présent mode de réalisation commence par l'étape de formation 410 d'une couche à base de nitrure 152 recouvrant un transistor 500, comme illustré précédemment en **figure 5a****.**

La **figure 5c** montre la structure du transistor 500 obtenue à l'issue d'une étape facultative de gravure anisotrope 320 de la couche à base de nitrure 152.

Optionnellement, après l'étape de formation 410 de la couche à base de nitrure 152 et préalable à l'étape de modification 430 de la couche à base de nitrure 152, on procède à une gravure anisotrope 320 de la couche à base de nitrure 152. Ceci est typiquement effectué dans un plasma de type CH3F/O2/He décrit précédemment. La gravure des espaceurs est ainsi, selon ce mode de réalisation optionnel et non limitatif, réalisée en deux étapes comprenant : une première étape dite de « gravure principale » réalisée de manière isotrope, et une seconde étape de finition généralement qualifiée de « surgravure » ou du terme anglophone de « over etching (OE) » ayant la même signification. C'est au cours de l'étape de surgravure (étapes 440) que l'on finira d'enlever le nitrure restant sur les surfaces horizontales, après avoir modifié (étape 430) la couche à base de nitrure 152 pour éviter ou limiter les problèmes décrits dans les **figures 1b** à **1d****.**

Dans le cadre de mises en oeuvre spécifiques de l'invention on peut décider de maintenir ou non l'étape de gravure anisotrope 320, les étapes suivantes s'appliquent alors soit sur la couche à base de nitrure telle que déposée ou sur la couche restante de nitrure après qu'une gravure principale a été préalablement effectuée comme dans le procédé standard de gravure des espaceurs.

L'étape suivante à réaliser est l'étape de modification 430 de la couche à base de nitrure 152 restant à l'issue de l'étape de gravure anisotrope 320. La structure du transistor 500 à l'issue de cette étape 430 est illustrée en **figure 5d****.**

Cette étape de modification 430 n'est pas différente de celle du mode de réalisation illustré précédemment en figures **5a, 5b** et **5e** ni de celle du mode de réalisation illustré précédemment en **figures 4a** à **4d****.**

L'étape de retrait 440 de la couche modifiée de la nitrure 158 est ensuite réalisée, comme illustré en **figure 5e****.** Cette étape de retrait 440 n'est pas différente de celle du mode de réalisation illustré précédemment en **figures 5a, 5b** et **5e** ni de celle du mode de réalisation illustré précédemment en **figures 4a** à **4d****.** Ce mode de réalisation permet d'enlever rapidement une forte épaisseur de nitrure par la gravure isotrope puis de contrôler avec précision l'épaisseur des espaceurs en effectuant les étapes 430 et 440.

Pour certaines applications il est nécessaire d'avoir un contrôle très précis du « facettage », c'est-à-dire du problème exposé dans la figure 1d, qui résulte des opérations de gravure conventionnelle et qui peut donc peut être induit par l'étape de gravure principale 320 qui est comme on l'a vu optionnelle. Avantageusement, pour pallier ce problème, on évitera donc cette étape qui sera remplacée par une répétition 450 des opérations de modification 430 de la couche à base de nitrure 152 et de retrait 440 de la couche modifiée 158, le retrait se faisant de préférence dans ce cas sous la forme d'un retrait par voie sèche comme décrit dans la figure 6 puisque, comme on la remarqué plus haut, les deux opérations peuvent se pratiquer dans le même réacteur de gravure.

De la description qui précède, il ressort de nombreux avantages conférés par l'invention. Le procédé de l'invention permet notamment une modification anisotrope réalisée de manière très sélective au carbone, au nitrure non-modifié qui constitue des espaceurs pour la grille et à un matériau semi-conducteur tel que le silicium.

Un film carboné formé lors de l'étape de modification du procédé résiste au bombardement des ions du plasma, ce qui permet de protéger la couche comprenant du carbone lors de l'étape de modification ainsi que lors de l'étape de retrait.

Le procédé de l'invention s'avère particulièrement avantageuse pour former les espaceurs de transistors de type MOSFET ou FinFET.

Le procédé de la présente invention permet de contrôler très précisément la dimension des espaceurs tout en s'affranchissant ou en réduisant les problèmes détaillés précédemment, par exemple : la consommation excessive de silicium de la couche active et/ou d'un masque de carbone ou d'une couche de résine photosensible typiquement comprenant du carbone, la formation de pieds au niveau des espaceurs de la grille à l'interface avec le substrat SOI tel que décrit en figures 1b et 1c ainsi que l'érosion des espaceurs de la grille tel que décrit en figure 1d.

L'invention n'est pas limitée aux seuls modes et exemples de réalisation décrits ci-dessus, mais s'étend à tous les modes de réalisation entrant dans la portée des revendications.

## Revendications

1. Procédé de formation d'espaceurs (152a, 152b) d'une grille (120) d'un transistor à effet de champ (200), la grille (120) étant située au-dessus d'une couche active (146) en un matériau semi-conducteur, comprenant une étape de formation (410) d'une couche à base de nitrure (152) recouvrant la grille (120) dudit transistor (200), le procédé étant **caractérisé en ce qu'**il comprend après l'étape de formation (410) de la couche à base de nitrure (152) :
- au moins une étape de modification (430) de la couche à base de nitrure (152) par mise en présence de la couche à base de nitrure (152) avec un plasma dans lequel on introduit du CxHy où x est la proportion de carbone et y est la proportion d'hydrogène (H) et comprenant des ions plus lourds que l'hydrogène ; les conditions du plasma, en particulier la concentration en CxHy, l'énergie des ions et la direction principale d'implantation étant choisies de manière à ce que :
o le plasma créé un bombardement d'ions à base d'hydrogène (H, H⁺, H₂⁺, H₃⁺ etc.) provenant du CxHy, le bombardement étant anisotrope selon une direction privilégiée parallèle à des flancs de la grille (120) et de sorte à modifier uniquement une portion supérieure (158) de l'épaisseur de la couche à base de nitrure (152) au niveau des flancs de la grille (120) en conservant des portions non-modifiées (152a, 152b) de la couche à base de nitrure (152) recouvrant les flancs de la grille (120),
o des espèces chimiques du plasma contenant du carbone provenant du CxHy forment un film carboné (271) notamment sur des surfaces parallèles à la direction du bombardement ;
o le plasma créé un bombardement des ions plus lourds que l'hydrogène qui empêche audites espèces chimiques du plasma contenant du carbone et provenant du CxHy de former un film carboné (271) notamment sur les surfaces de la couche à base de nitrure (152) qui sont perpendiculaires à la direction du bombardement;
- au moins une étape de retrait (440) de la couche modifiée (158) à base de nitrure à l'aide d'une gravure sélective de la couche modifiée (158) à base de nitrure vis-à-vis des portions non-modifiées (152a, 152b) de la couche à base de nitrure (152).

2. Procédé selon la revendication 1 comprenant, préalablement à l'étape de modification (430) une étape de dépôt (310) d'une couche (311) comprenant du carbone, cette couche (311) comprenant du carbone étant distincte dudit transistor (200), et dans lequel ladite gravure est sélective de la couche modifiée (158) à base de nitrure vis-à-vis du carbone (271) et vis-à-vis des portions non-modifiées (152a, 152b) de la couche à base de nitrure (152).

3. Procédé selon la revendication précédente dans lequel la couche (311) comprenant du carbone est une couche de résine photosensible ou thermosensible.et de préférence dans lequel la couche (311) comprenant du carbone est configurée pour recouvrir une structure (300) distincte dudit transistor (200).

4. Procédé selon l'une quelconque des revendications précédentes dans lequel le CxHy est du CH4.

5. Procédé selon l'une quelconque des revendications précédentes dans lequel les ions plus lourds que l'hydrogène sont pris parmi l'argon (Ar), l'hélium (He), l'azote (N2), le xénon (Xe) et l'oxygène (02).

6. Procédé selon l'une quelconque des revendications précédentes dans lequel l'étape de modification (430) est réalisée de manière à ce que le plasma génère un bombardement des ions plus lourds que l'hydrogène de manière anisotrope selon une direction privilégiée parallèle aux flancs de la grille (120) de sorte à empêcher audites espèces chimiques du plasma contenant du carbone provenant du CxHy de former un film carboné (271) sur les surfaces perpendiculaires aux flancs de la grille (120).

7. Procédé selon l'une quelconque des revendications précédentes dans lequel l'étape de modification (430) est réalisée de manière à ce que les ions plus lourds que l'hydrogène du plasma dissocient la molécule du CxHy de sorte à permettre aux ions hydrogène (H) provenant du CxHy de former des ions à base d'hydrogène et de s'implanter dans ladite portion (158) de la couche à base de nitrure (152).

8. Procédé selon l'une quelconque des revendications précédentes dans lequel l'étape de retrait (440) de la portion modifiée (158) à base de nitrure est effectuée par gravure sélectivement à la couche active (146).

9. Procédé selon l'une quelconque des revendications précédentes dans lequel lors de l'étape de modification (430) les conditions du plasma, en particulier la concentration en CxHy, l'énergie des ions et la direction principale d'implantation sont choisies de manière à ce que, au niveau des surfaces perpendiculaires à la direction d'implantation, tout l'épaisseur de la couche à base de nitrure (152) soit modifiée par l'implantation des ions à base d'hydrogène et dans lequel l'étape de retrait (440) est réalisée de manière à retirer toute la couche modifiée (158), mettant ainsi à nu la couche active (146) au niveau des surfaces perpendiculaires à la direction d'implantation.

10. Procédé selon l'une quelconque des revendications précédentes dans lequel le matériau semi-conducteur est du silicium et dans lequel l'étape de retrait (440) de la couche modifiée (158) à base de nitrure est effectuée par gravure humide sélectivement audit matériau semi-conducteur de la couche active (146) et/ou à l'oxyde de silicium (SiO2) et de préférence dans lequel la gravure sélective au silicium est obtenue à l'aide d'une solution à base d'acide fluorhydrique (HF) ou de H3PO4.

11. Procédé selon l'une quelconque des revendications 1 à 9 dans lequel l'étape de retrait (440) est effectuée par gravure sèche sélective de ladite couche modifiée à base de nitrure (158) vis-à-vis dudit film carboné (271), vis-à-vis des portions non-modifiées (152a, 152b) de la couche à base de nitrure (152) et vis-à-vis dudit matériau semi-conducteur et de préférence dans lequel la gravure sèche est effectuée dans un plasma formé dans une enceinte confinée à partir de trifluorure d'azote (NF3) et d'ammoniac (NH3).

12. Procédé selon la revendication précédente dans lequel la gravure sèche comprend :
une étape de gravure (620) consistant en la formation de sels solides ;
une étape de sublimation (630) des espèces solides.

13. Procédé selon l'une quelconque des revendications précédentes comprenant plusieurs séquences comprenant chacune une étape de modification (430) et une étape de retrait (440), et dans lequel au cours d'au moins l'une des étapes de modification (430), seule une partie de l'épaisseur de la couche de nitrure (152) est modifiée et de préférence dans lequel les séquences sont répétées (450) jusqu'à disparition de la couche modifiée (158) à base de nitrure sur toutes les surfaces parallèles au plan d'un substrat sur lequel repose la grille (120).

14. Procédé selon l'une quelconque des revendications 1 à 12 dans lequel l'étape de modification (430) est une unique étape effectuée de manière à modifier la couche à base de nitrure (152) dans toute son épaisseur sur toutes les surfaces parallèles au plan d'un substrat sur lequel repose la grille (120) et à ne pas modifier la couche à base de nitrure (152) dans toute son épaisseur sur les surfaces perpendiculaires à ce plan et de préférence dans lequel l'étape de modification est précédée d'une étape de gravure (420) isotrope qui est effectuée dans un plasma de type CH3F/O2/He.

15. Procédé selon l'une quelconque des revendications précédentes dans lequel l'étape de modification (430) réalisée à partir d'un plasma modifie la couche à base de nitrure (152) de manière continue depuis la surface de la couche à base de nitrure (152) et sur une épaisseur comprise entre 1 nm et 30nm et de préférence entre 1 nm et 10 nm.

## Patentansprüche

1. Verfahren zur Herstellung von Abstandshaltern (152a, 152b) eines Gates (120) eines Feldeffekttransistors (200), wobei das Gate (120) über einer aktiven Schicht (146) aus einem Halbleitermaterial angeordnet ist, umfassend einen Schritt der Herstellung (410) einer Schicht auf Basis von Nitrid (152), die das Gate (120) des Transistors (200) bedeckt, wobei das Verfahren **dadurch gekennzeichnet ist, dass** es nach dem Schritt der Herstellung (410) der Schicht auf Basis von Nitrid (152) umfasst:
- mindestens einen Schritt der Modifikation (430) der Schicht auf Basis von Nitrid (152) durch Inkontaktbringen der Schicht auf Basis von Nitrid (152) mit einem Plasma, in das CxHy eingeleitet wird, wobei x der Kohlenstoffanteil und y der Wasserstoffanteil (H) ist, und umfassend Ionen, die schwerer sind als der Wasserstoff; wobei die Bedingungen des Plasmas, insbesondere die Konzentration an CxHy, die Energie der Ionen und die Haupteinsetzrichtung derart gewählt sind, dass:
∘ das Plasma einen Ionenbeschuss auf Basis von Wasserstoff (H, H⁺, H₂⁺, H₃⁺, usw.), stammend von dem CxHy, erzeugt, wobei der Beschuss anisotrop in eine bevorzugte Richtung parallel zu Seiten des Gates (120) ist, und um nur einen oberen Abschnitt (158) der Dicke der Schicht auf Basis von Nitrid (152) im Bereich der Seiten des Gates (120) zu modifizieren, wobei nicht modifizierte Abschnitte (152a, 152b) der Schicht auf Basis von Nitrid (152) bewahrt bleiben, die die Seiten des Gates (120) bedecken,
∘ chemische Spezies des Plasmas, die Kohlenstoff enthalten, stammend von dem CxHy, einen Kohlenstofffilm (271) insbesondere auf Flächen parallel zur Richtung des Beschusses bilden;
∘ das Plasma einen Beschuss der Ionen, die schwerer als der Wasserstoff sind, erzeugt, der die chemischen Spezies des Plasmas, die Kohlenstoff enthalten, stammend von dem CxHy, daran hindert, einen Kohlenstofffilm (271) insbesondere auf den Flächen der Schicht auf Basis von Nitrid (152) zu bilden, die zur Richtung des Beschusses senkrecht stehen;
- mindestens einen Schritt des Abhebens (440) der modifizierten Schicht (158) auf Basis von Nitrid mit Hilfe einer selektiven Gravur der modifizierten Schicht (158) auf Basis von Nitrid gegenüber nicht modifizierten Abschnitten (152a, 152b) der Schicht auf Basis von Nitrid (152).

2. Verfahren nach Anspruch 1, umfassend vor dem Schritt der Modifikation (430) einen Schritt (310) des Aufbringens eines Schicht (311), umfassend Kohlenstoff, wobei diese Kohlenstoff umfassende Schicht (311) vom Transistor (200) getrennt ist, und bei dem die Gravur selektiv auf der modifizierten Schicht (158) auf Basis von Nitrid gegenüber dem Kohlenstoff (271) und gegenüber den nicht modifizierten Abschnitten (152a, 152b) der Schicht auf Basis von Nitrid (152) erfolgt.

3. Verfahren nach dem vorhergehenden Anspruch, bei dem die Schicht (311) umfassend Kohlenstoff, eine Schicht von photosensiblem oder thermosensiblem Harz ist, und bei dem vorzugsweise die Schicht (311), umfassend Kohlenstoff, dazu vorgesehen ist, eine vom Transistor (200) getrennte Struktur (300) zu bedecken.

4. Verfahren nach einem der vorhergehenden Ansprüche, bei dem das CxHy CH4 ist.

5. Verfahren nach einem der vorhergehenden Ansprüche, bei dem die Ionen, die schwerer sind als der Wasserstoff, unter dem Argon (Ar), Helium (He), Stickstoff (N2), Xenon (Xe) und Sauerstoff (02) ausgewählt sind.

6. Verfahren nach einem der vorhergehenden Ansprüche, bei dem der Modifikationsschritt (430) derart erfolgt, dass das Plasma einen Beschuss der Ionen, die schwerer sind als der Wasserstoff, auf anisotrope Weise in eine bevorzugte Richtung parallel zu den Seiten des Gates (120) erzeugt, um die chemischen Spezies des Plasmas, die Kohlenstoff enthalten, stammend von dem CxHy, daran zu hindern, einen Kohlenstofffilm (271) auf den Flächen senkrecht auf die Seiten des Gates (120) zu bilden.

7. Verfahren nach einem der vorhergehenden Ansprüche, bei dem der Modifikationsschritt (430) derart erfolgt, dass die Ionen, die schwerer sind als der Wasserstoff, des Plasmas das Molekül des CxHy abtrennen, um es den Wasserstoffionen (H), die von dem CxHy stammen, zu ermöglichen, Ionen auf Basis von Wasserstoff zu bilden und sich in den Abschnitt (158) der Schicht auf Basis von Nitrid (152) zu setzen.

8. Verfahren nach einem der vorhergehenden Ansprüche, bei dem der Schritt des Abhebens (440) des modifizierten Abschnitts (158) auf Basis von Nitrid durch Gravur selektiv an der aktiven Schicht (146) durchgeführt wird.

9. Verfahren nach einem der vorhergehenden Ansprüche, bei dem bei dem Modifikationsschritt (430) die Bedingungen des Plasmas, insbesondere die Konzentration an CxHy, die Energie der Ionen und die Haupteinsetzrichtung derart gewählt sind, dass im Bereich der Flächen senkrecht auf die Einsetzrichtung die gesamte Dicke der Schicht auf Basis von Nitrid (152) durch das Einsetzen der Ionen auf Basis von Wasserstoff modifiziert wird, und bei dem der Schritt des Abhebens (440) derart erfolgt, dass die gesamte modifizierte Schicht (158) abgehoben wird, wodurch die aktive Schicht (146) im Bereich der Flächen senkrecht auf die Einsetzrichtung freigelegt wird.

10. Verfahren nach einem der vorhergehenden Ansprüche, bei dem das Halbleitermaterial Silizium ist, und bei dem der Schritt des Abhebens (440) der modifizierten Schicht (158) auf Basis von Nitrid durch Feuchtgravur selektiv am Halbleitermaterial der aktiven Schicht (146) und/oder am Siliziumoxid (Si02) erfolgt, und bei dem vorzugsweise die selektive Gravur am Silizium mit Hilfe einer Lösung auf Basis von Fluorwasserstoffsäure (HF) oder von H3P04 erhalten wird.

11. Verfahren nach einem der Ansprüche 1 bis 9, bei dem der Schritt des Abhebens (440) durch selektive Trockengravur der modifizierten Schicht auf Basis von Nitrid (158) gegenüber dem Kohlenstofffilm (271), gegenüber den nicht modifizierten Abschnitten (152a, 152b) der Schicht auf Basis von Nitrid (152) und gegenüber dem Halbleitermaterial erfolgt, und bei dem vorzugsweise die Trockengravur in einem Plasma erfolgt, das in einem eingegrenzten Bereich aus Stickstoff- (NF3) und Ammoniak-Trifluorid (NH3) gebildet ist.

12. Verfahren nach dem vorhergehenden Anspruch, bei dem die Trockengravur umfasst:
einen Schritt der Gravur (620), der in der Bildung von festen Salzen besteht;
einen Schritt der Sublimation (630) der festen Spezies.

13. Verfahren nach einem der vorhergehenden Ansprüche, umfassend mehrere Sequenzen, umfassend jeweils einen Schritt der Modifikation (430) und einen Schritt des Abhebens (440), und bei dem während mindestens einem der Modifikationsschritte (430) nur ein Teil der Dicke der Nitridschicht (152) modifiziert wird, und bei dem vorzugsweise die Sequenzen wiederholt werden (450), bis die modifizierte Schicht (158) auf Basis von Nitrid auf allen Flächen parallel zur Ebene eines Substrats, auf dem das Gate (120) liegt, verschwunden ist.

14. Verfahren nach einem der Ansprüche 1 bis 12, bei dem der Modifikationsschritt (430) ein einziger Schritt ist, der derart ausgeführt wird, dass die Schicht auf Basis von Nitrid (152) in ihrer gesamten Dicke auf allen Flächen parallel zur Ebene eines Substrats, auf dem das Gate (120) liegt, modifiziert wird, und dass die Schicht auf Basis von Nitrid (152) in ihrer gesamten Dicke auf den Flächen senkrecht auf diese Ebene nicht modifiziert wird, und bei dem vorzugsweise dem Modifikationsschritt ein Schritt der isotropen Gravur (420) vorangeht, der in einem Plasma vom Typ CH3F/02/He durchgeführt wird.

15. Verfahren nach einem der vorhergehenden Ansprüche, bei dem der aus einem Plasma durchgeführte Modifikationsschritt (430) die Schicht auf Basis von Nitrid (152) kontinuierlich von der Oberfläche der Schicht auf Basis von Nitrid (152) ausgehend und auf einer Dicke zwischen 1 nm und 30 nm und vorzugsweise zwischen 1 nm und 10 nm modifiziert.

## Claims

1. A method for forming spacers (152a, 152b) of a field effect transistor (200) gate (120), with the gate (120) being located above an active layer (146) made of a semiconductor material, comprising a step (410) of forming (410) a nitride-based layer (152) overlying the gate (120) of said transistor (200), with the method being **characterized in that** it comprises, after the step of forming (410) the nitride-based layer (152):
- at least a step of modifying (430) the nitride-based layer (152) by contacting the nitride-based layer (152) with plasma wherein CxHy is introduced where x is the proportion of carbon and y is the proportion of hydrogen ions (H), and comprising ions heavier than hydrogen; with the conditions of plasma, more particularly the concentration of CxHy, the ion energy and the main implantation direction being so chosen that:
∘ plasma creates an anisotropic bombardment with hydrogen-based ions (H, H⁺, H₂⁺, H₃⁺ etc.) from CxHy, with the bombardment being anisotropic in a direction parallel to flanks of the gate (120) and so as to modify an upper portion (158) of the thickness of the nitride-based layer (152) at the level of the flanks of the gate (120) only, while keeping non-modified portions (152a, 152b) of the nitride-based layer (152) covering the flanks of the gate (120).
∘ plasma chemical species containing carbon from CxHy form a carbon film (271) specifically on surfaces parallel to the direction of the bombardment;
∘ plasma creates a bombardment with ions heavier than hydrogen which prevents said carbon-containing plasma chemical species from CxHy from forming a carbon film (271), more particularly on the surfaces of the nitride-based layer (152) which are perpendicular to the direction of the bombardment.
- at least a step of removing (440) the nitride-based modified layer (158) using a selective etching of the nitride-based modified layer (158) relative to non-modified portions (152a, 152b) of the nitride-based layer (152).

2. A method according to claim 1, comprising, prior to the step of modifying (430), a step of depositing (310) a layer (311) comprising carbon, with such layer (311) comprising carbon being different from said transistor (200), and wherein said etching is selective of the nitride-based modified layer (158) to carbon (271) and to non-modified portions (152a, 152b) of the nitride-based layer (152).

3. A method according to the preceding claim, wherein the layer (311) comprising carbon is a layer of photo-sensitive or thermo-sensitive resin and preferably, wherein the layer (311) comprising carbon is so configured as to cover a structure (300) different from said transistor (200).

4. A method according to any one of the preceding claims, wherein CxHy is CH4.

5. A method according to any one of the preceding claims, wherein the ions heavier than hydrogen are selected among argon (Ar), helium (HE), nitrogen (N2), xenon (Xe) and oxygen (02).

6. A method according to any one of the preceding claims, wherein the step of modifying (430) is so executed that the plasma generates an anisotropic bombardment with ions heavier than hydrogen according to a favorite direction parallel to the flanks of the gate (120), so as to prevent said carbon-containing plasma chemical species from CxHy from forming a carbon film (271) on the surfaces perpendicular to the flanks of the gate (120).

7. A method according to any one of the preceding claims, wherein the step of modifying (430) is so executed that the ions heavier than hydrogen of plasma dissociate the CxHy molecule so as to enable the hydrogen ions (H) from CxHy to form hydrogen-based ions and to implant into said portion (158) of the nitride-based layer (152).

8. A method according to any one of the preceding claims, wherein the step of removing (440) the nitride-based modified portion (158) is executed using selective etching of the active layer (146).

9. A method according to any one of the preceding claims, wherein during the step of modifying (430) the conditions of plasma, more particularly the concentration of CxHy, the ion energy and the main implantation direction are so selected that, at the level of the surfaces perpendicular to the implantation direction, the whole thickness of the nitride-based layer (152) is modified by the implantation of hydrogen-based ions and wherein the step of removing (440) is so executed as to remove the whole thickness of the modified layer (158), thus exposing the active layer (146) at the level of the surfaces perpendicular to the implantation direction.

10. A method according to any one of the preceding claims, wherein the semi-conductor material is silicon and wherein the step of removing (440) the nitride-based modified layer (158) is executed using wet etching selectively to said semi-conductor material of the active layer (146) and/or silicon oxide (SiO2) and preferably wherein selective silicon etching is executed using a hydrofluoric acid (HF) based solution or H3PO4.

11. A method according to any one of claims 1 to 9, wherein the step of removing (440) is executed using selective dry etching of said nitride-based modified layer (158) to said carbon film (271), to the non-modified portions (152a, 152b) of the nitride-based layer (152) and to said semi-conductor material and preferably wherein dry etching is executed in plasma formed in a confined chamber from nitrogen trifluoride (NF3) and ammonia (NH3).

12. A method according to the preceding claim, wherein dry etching comprises:
a step of etching (620) consisting in forming solid salts;
a step of sublimating (630) the solid species.

13. A method according to any one of the preceding claims comprising several sequences, each comprising a step of modifying (430) and a step of removing (440), and wherein, during at least one of the steps of modification (430), a part of the thickness of the nitride layer (152) only is modified and preferably wherein the sequences are repeated (450) until the nitride-based modified layer (158) has disappeared on all the surfaces parallel to the plane of a substrate whereon the gate (120) is supported.

14. A method according to any one of claims 1 to 12, wherein the step of modifying (430) is a single step so executed as to modify the whole thickness of the nitride-based layer (152) over all the surfaces parallel to the plane of a substrate whereon the gate (120) is supported and not to modify the whole thickness of nitride-based layer (152) on the surfaces perpendicular to this plane and preferably wherein the step of modifying is preceded by a step of isotropic etching (420) which is executed in a plasma of the CH3F/O2/He type.

15. A method according to any one of the preceding claims, wherein the step of modifying (430) executed from plasma continuously modifies the nitride-based layer (152) from the surface of the nitride-based layer (152) and on a thickness ranging from 1 nm to 30nm and preferably from 1 nm to 10nm.
